# EUROPEAN PATENT APPLICATION

(11) **EP 4 622 431 A1**
(43) Date of publication of application: **24.09.2025**
(21) Application number: 25164487.8
(22) Date of filing: 18.03.2025
(51) Int. Cl.: H10K 59/124, H10K 59/131, H10K 77/10

(54) **DISPLAY PANEL, ELECTRONIC DEVICE, METHOD FOR MANUFACTURING DISPLAY PANEL**

(30) Priority: 21.03.2024 KR 20240038924
(71) Applicant: Samsung Display Co., Ltd., Yongin-si, Gyeonggi-do 17113 (KR)
(72) Inventor: Kim, Daesoo, 17113 Giheung-Gu, Yongin-si, Gyeonggi-Do (KR); Seo, Dongkyun, 17113 Giheung-Gu, Yongin-si, Gyeonggi-Do (KR); Jung, Yang-Ho, 17113 Giheung-Gu, Yongin-si, Gyeonggi-Do (KR); Kim, Sanggab, 17113 Giheung-gu, Yongin-si, Gyeonggi-do (KR)
(74) Representative: Dr. Weitzel & Partner

(57) **Abstract**

A display panel includes a first base layer in which an opening is defined, a pad electrode disposed on the first base layer and exposed to an outside through the opening, a second base layer which is disposed on the pad electrode and in which a first contact hole is defined, a protective layer which is disposed on the second base layer and in which a second contact hole overlapped with the first contact hole is defined, and a connection electrode disposed on the protective layer and electrically connected to a pad electrode through the first contact hole and the second contact hole. The second contact hole has a width greater than a width of the first contact hole.

## Description

### BACKGROUND

### 1. Field

Embodiments of the invention described herein relate to a display panel, an electronic device, and a method for manufacturing the display panel, and more particularly, relate to a display panel, an electronic device, and a method for manufacturing the display panel, which are improved in reliability.

### 2. Description of the Related Art

Electronic devices, such as a smartphone, a tablet personal computer ("PC"), a notebook computer, a navigation for a vehicle, and a smart television, are being developed. The electronic devices include a display device to provide information.

The display device is being developed in various forms to satisfy a user experience/user interface ("UX/UI") of a user. The display device has been developed to provide a wider display region, and a narrower non-display region.

### SUMMARY

The invention is defined by the independent claims. Embodiments of the invention provide a display panel, which is manufactured in a simplified method and improved in display quality, an electronic device, and a method for manufacturing the display panel.

According to the invention, a display panel includes a first base layer in which an opening is defined, a pad electrode disposed on the first base layer and exposed to an outside through the opening, a second base layer which is disposed on the pad electrode and in which a first contact hole is defined, a protective layer which is disposed on the second base layer and in which a second contact hole, which is overlapped with the first contact hole, defined in the protective layer, is defined and a connection electrode disposed on the protective layer and electrically connected to the pad electrode through the first contact hole and the second contact hole. The second contact hole has a width greater than a width of the first contact hole.

In an embodiment of the invention, the display panel may further include a base insulating layer interposed between the first base layer and the second base layer, and a third contact hole may be defined in the base insulating layer while passing through the base insulating layer.

In an embodiment, the third contact hole may have a width different from a width of the first contact hole.

In an embodiment, a first side surface, which defines the first contact hole, and a second side surface, which defines the third contact hole, may be aligned in line with each other.

In an embodiment, the base insulating layer may include a first sub-base insulating layer disposed on the first base layer, and a second sub-base insulating layer disposed on the first sub-base insulating layer and the pad electrode, and the pad electrode may be disposed in a base opening defined in the first sub-base insulating layer.

In an embodiment, the third contact hole may be defined in the second sub-base insulating layer, and the third contact hole may be overlapped with the base opening.

In an embodiment, the pad electrode may include a first part overlapped with the opening, and a second part extending in a first direction from the first part.

In an embodiment, the connection electrode directly may contact the first part.

In an embodiment, the connection electrode directly may contact the second part.

In an embodiment, the second base layer may include an organic material.

In an embodiment, the protective layer may include at least one inorganic layer.

In an embodiment, the second base layer may have a thickness greater than a thickness of the protective layer.

In an embodiment, the first base layer may include a display region and a non-display region, and the pad electrode may be overlapped with the non-display region.

According to another aspect of the invention, an electronic device includes a display panel to display an image, and a circuit board coupled to the display panel. The display panel includes a first base layer in which an opening is defined, a pad electrode disposed on the first base layer and exposed to an outside through the opening, a second base layer which is disposed on the pad electrode and in which a first contact hole is defined, a protective layer which is disposed on the second base layer and in which a second contact hole, which is overlapped with the first contact hole, defined in the protective layer, is defined and a connection electrode disposed on the protective layer and electrically connected to the pad electrode through the first contact hole and the second contact hole. The second contact hole has a width greater than a width of the first contact hole.

In an embodiment, the display panel may include a first sub-base insulating layer disposed on the first base layer, and a second sub-base insulating layer disposed on the first sub-base insulating layer and the pad electrode, and the pad electrode may be disposed in a base opening defined in the first sub-base insulating layer.

In an embodiment, a third contact hole may be defined in the second sub-base insulating layer, and the third contact hole may have a width different from a width of the first contact hole.

In an embodiment, each of the first contact hole and the second contact hole may be overlapped with the opening.

In an embodiment of the invention, the electronic device may further include a metal pattern to electrically connect the display panel to the circuit board.

In an embodiment, the display panel may include a first sub-base insulating layer disposed on the first base layer, the circuit board may include a base film, and a bump electrode interposed between the base film and the first sub-base insulating layer, and the bump electrode and the pad electrode may be electrically connected to each other through the metal pattern.

In an embodiment of the invention, the electronic device may further include an adhesive layer interposed between the bump electrode and the first sub-base insulating layer.

In an embodiment of the invention, a method for manufacturing a display panel includes forming a pad electrode on a first preliminary base layer, forming a second preliminary base layer on the first preliminary base layer and the pad electrode, forming a preliminary protective layer on the second preliminary base layer, forming a second base layer in which a first contact hole is defined by etching the second preliminary base layer, and forming a protective layer in which a second contact hole is defined by etching the preliminary protective layer, and forming a connection electrode disposed on the protective layer and electrically connected to the pad electrode through the first contact hole and the second contact hole. The second contact hole has a width greater than a width of the first contact hole.

In an embodiment of the invention, the method further includes forming a base insulating layer which is interposed between the first preliminary base layer and the second base layer and in which a third contact hole defined in the base insulating layer.

In an embodiment, the forming the base insulating layer may include forming a first sub-base insulating layer, in which a base opening is defined, on the first preliminary base layer, and forming a second sub-base insulating layer disposed on the first sub-base insulating layer and the pad electrode.

In an embodiment, the forming the second sub-base insulating layer may include defining the third contact hole overlapped with the first contact hole.

In an embodiment, the defining the third contact hole may be performed simultaneously with the defining the first contact hole and the second contact hole.

In an embodiment, the defining the third contact hole may be performed after the defining the first contact hole, and the third contact hole may have a width smaller than a width of the first contact hole.

In an embodiment, the forming the pad electrode may include forming a metal layer on the first sub-base insulating layer, and forming a pad electrode by etching the metal layer.

In an embodiment, the etching the second preliminary base layer and the preliminary protective layer may include defining the first contact hole by performing a first etching process for the preliminary protective layer, and defining the second contact hole by performing a second etching process for the second preliminary base layer.

In an embodiment, the second etching process may be performed after the first etching process.

In an embodiment of the invention, the method may further include forming an opening, which exposes the pad electrode to an outside, in the first preliminary base layer.

### BRIEF DESCRIPTION OF THE DRAWINGS

The above and other embodiments, advantages and features of the invention will become apparent by describing in detail embodiments thereof with reference to the accompanying drawings.
FIG. 1 is a perspective view of an embodiment of an electronic device according to the invention.
FIG. 2 is an exploded perspective view of an embodiment of an electronic device according to the invention.
FIG 3 is a cross-sectional view of a display device taken along line I-I' of FIG. 2.
FIG. 4 is a cross-sectional view illustrating an embodiment of a display module according to the invention in brief.
FIG. 5 is a plan view of an embodiment of a display panel according to the invention.
FIG. 6 is a cross-sectional view of an embodiment of a display module according to the invention.
FIG. 7 is a plan view of an embodiment of a display panel according to the invention.
FIG. 8 is an enlarged view illustrating an embodiment of a portion of a display device according to the invention.
FIG. 9A is a cross-sectional view illustrating a portion of a display device taken along line II-II' of FIG. 8.
FIG. 9B is an enlarged view illustrating region AA' illustrated in FIG. 9A.
FIGS. 10A and 10B are enlarged plan views illustrating an embodiment of a portion of a display device according to the invention.
FIG. 11 is a cross-sectional view illustrating an embodiment of a portion of a display device according to the invention.
FIGS. 12A to 12H are views illustrating one operation in a method for manufacturing a display device.
FIGS. 13A and 13B are views illustrating one operation in a method for manufacturing a display device.

### DETAILED DESCRIPTION

While the invention is susceptible to various modifications and alternative forms, illustrative embodiments thereof are shown by way of example in the drawings and will be described herein in detail. It should be understood, however, that there is no intent to limit the invention to the particular forms disclosed, but on the contrary, the invention is to cover all modifications and alternatives falling within the scope of the invention.

In the specification, the expression that a first component (or region, layer, part, portion, etc.) is "on", "connected to", or "coupled to" a second component means that the first component is directly on, connected to, or coupled to the second component or means that a third component is interposed therebetween.

The same reference numeral will be assigned to the same component. In addition, in drawings, thicknesses, proportions, and dimensions of components may be exaggerated to describe the technical features effectively.

The term "and/or" includes any and all combinations of one or more of associated components.

Although the terms "first", "second", etc. may be used to describe various components, the components should not be construed as being limited by the terms. The terms are only used to distinguish one component from another component. In an embodiment, without departing from the scope of the invention, a first component may be also referred to as a second component, and similarly, the second component may be also referred to as the first component, for example. The singular forms are intended to include the plural forms unless the context clearly indicates otherwise.

In addition, the terms "under", "at a lower portion", "above", "an upper portion" are used to describe the relationship between components illustrated in drawings. The terms are relative and are described with reference to a direction indicated in the drawing.

Unless otherwise defined, all terms (including technical terms and scientific terms) used in the specification have the same meaning as commonly understood by one skilled in the art to which the invention belongs. Such terms as those defined in a generally used dictionary are to be interpreted as having meanings equal to the contextual meanings in the relevant field of art, and are not to be interpreted as having ideal or excessively formal meanings unless clearly defined herein.

It will be further understood that the terms "comprises," "comprising," "includes," or "including," or "having" specify the presence of stated features, numbers, steps, operations, components, parts, or the combination thereof, but do not preclude the presence or addition of one or more other features, numbers, steps, operations, components, components, and/or the combination thereof.

Hereinafter, embodiments of the invention will be described with reference to accompanying drawings.

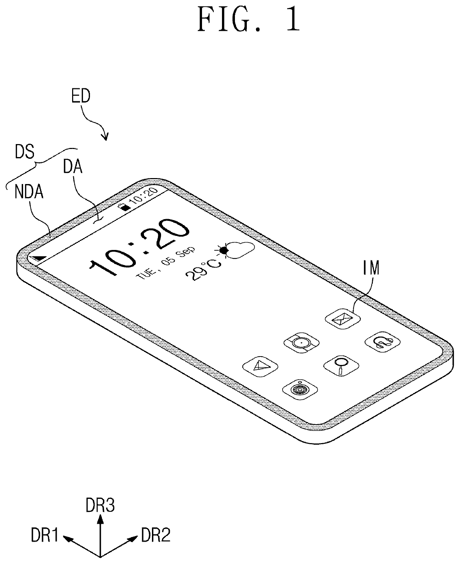

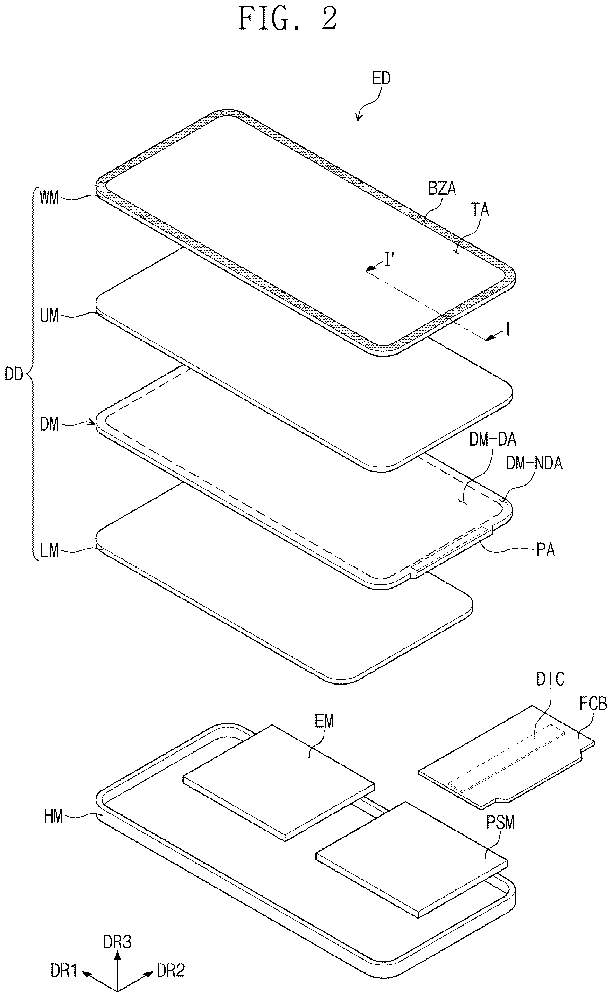

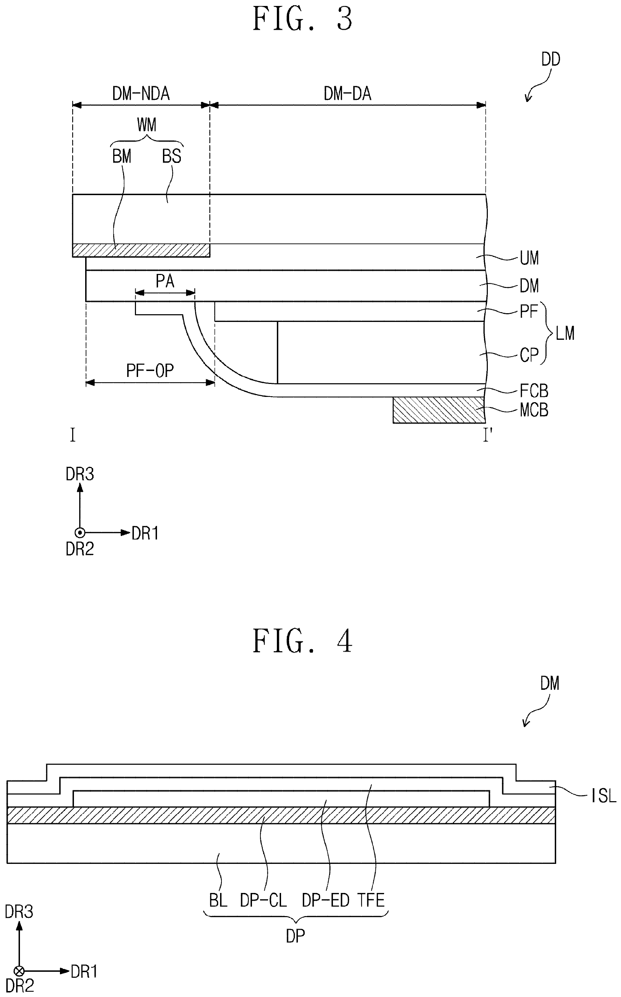

FIG. 1 is a perspective view of an embodiment of an electronic device according to the invention. FIG. 2 is an exploded perspective view of an embodiment of an electronic device according to the invention. FIG. 3 is a cross-sectional view of a display device taken along line I-I' of FIG. 2.

Referring to FIG. 1, an electronic device ED in an embodiment of the invention may include a display surface DS defined by a first direction DR1 and a second direction DR2 crossing the first direction DR1. The electronic device ED may provide an image IM to the user through the display surface DS.

The display surface DS may include a display region DA and a non-display region NDA around the display region DA. The display region DA may display the image IM, and the non-display region NDA may not display the image IM. The non-display region NDA may surround the display region DA. However, the invention is not limited thereto, and the form of the display region DA and the form of the non-display region NDA may be deformed.

Hereinafter, a direction substantially perpendicular to a plane defined by the first direction DR1 and the second direction DR2 is defined as a third direction DR3. The third direction DR3 may serve as a basis for distinguishing between a front surface and a rear surface of members. In this specification, the wording "in a plan view" may refer to the state when the display device DD is viewed in the third direction DR3.

In an embodiment of the invention, the electronic device ED may be a foldable electronic device to be folded about a folding axis. The folding axis may be parallel to the first direction DR1 or the second direction DR2, and a folding region may be defined in a portion of the display region DA. The electronic device ED may be in an in-folding state in which display regions DA face each other, or in an out-folding state in which the display regions DA are away from each other.

As illustrated in FIG. 2, the electronic device ED may include the display device DD, an electronic module EM, a power supply module PSM, and a housing HM. Although FIG. 2 illustrates the electronic device ED in brief, and the electronic device ED may further include a mechanism structure (e.g., a hinge) to control an operation (e.g., folding or rolling) of the display device DD.

The display device DD generates the image IM and detects an external input. The display device DD includes a window WM, an upper member UM, a display module DM, a lower member LM, a circuit board (or a flexible circuit board) FCB, and a driving chip DIC. The upper member UM includes members disposed above the display module DM, and the lower member LM includes members disposed below the display module DM.

The window WM provides a front surface of the electronic device ED. The window WM includes a transmission region TA and a bezel region BZA. The display region DA and the non-display region NDA of the display surface DS illustrated in FIG. 1 are defined by the transmission region TA and the bezel region BZA. The transmission region TA is a region through which an image passes, and the bezel region BZA is a region to cover a structure/member disposed under the window WM.

The display module DM includes a display region DM-DA and a non-display region DM-NDA corresponding to the display region DA and the non-display region NDA illustrated in FIG. 1. In the invention, the wording "a region/part correspond to a region/part" refers to that the region/part is overlapped with the region/part, and does not refer to that the region/part has an area the same as an area of the region/part.

A pad region PA is disposed at one side of the non-display region DM-NDA. The pad region PA is a region for electrically bonding (connecting) with the circuit board FCB to be described below. In an embodiment, the pad region PA may be defined on a rear surface of the display module DM.

The display module DM has substantially the shape of a rectangle. In this case, the expression "the substantial shape of a rectangle" includes the shape of a like rectangle perceived by a user as a rectangle, in addition to the shape of a rectangle having the meaning of mathematics. In an embodiment, the substantial shape of the rectangle may include the shape of a rectangle having a rounded corner, for example. In addition, for the substantial shape of the rectangle, the edge of a display panel DP is not limited to a straight line, but the edge may include a curved region.

The upper member UM may include a protective film or an optical film. The optical film may include a polarizer and a retarder to reduce reflection of external light. The lower member LM may include a protective film to protect the display panel DP, a support member to support the display panel DP, or a digitizer. The details of the upper member UM and the lower member LM will be described below.

The circuit board FCB is disposed under the display module DM. The circuit board FCB may be bonded to the rear surface of the display panel DP. The circuit board FCB electrically connects the display panel DP to a main circuit board MCB (refer to FIG. 3). The circuit board FCB includes at least one insulating layer and at least one conductive layer. The conductive layer may include a plurality of signal lines.

The driving chip DIC may be disposed (e.g., mounted) on the circuit board FCB. The driving chip DIC may include a driving circuit to drive a pixel of the display panel DP, e.g., a data driving circuit. Although FIG. 2 illustrates a structure in which the driving chip DIC is disposed (e.g., mounted) on the circuit board FCB, the invention is not limited thereto. In an embodiment, the driving chip DIC may be disposed (e.g., mounted) on the display module DM or the main circuit board MCB, for example.

The electronic module EM may include a control module, a wireless communication module, an image input module, a sound input module, a sound output module, a memory, or an external interface module. The electronic module EM may include a main circuit board, and the modules may be disposed (e.g., mounted) on the main circuit board or may be electrically connected to the main circuit board through the flexible circuit board. The electronic module EM is electrically connected to the power supply module PSM.

Although not illustrated separately, the electronic device ED may further include an electronic optical module. The electronic optical module may be an electronic component to output or receive an optical signal. The electronic optical module may include a camera module and/or a proximity sensor. The camera module may photograph an external image through a partial region of the display panel DP.

The housing HM illustrated in FIG. 2 is coupled to the display device DD, especially, the window WM to receive other modules. Although the housing HM is illustrated to have an integral shape, the invention is not limited thereto. The housing HM may include a plurality of parts (e.g., a side edge part and a bottom part) coupled to each other.

Referring to FIG. 3, the window WM may include a base substrate BS and a bezel pattern BM disposed on a bottom surface of the base substrate BS. The base substrate BS may include a synthetic resin film or a glass substrate. The base substrate BS may have a multi-layer structure. The base substrate BS may include a thin film glass substrate, a protective film disposed on a thin film glass substrate, and an adhesive layer to bond the thin film glass substrate to the protective film.

The bezel pattern BM, which serves as a colored light-blocking film, may be formed through a coating scheme. The bezel pattern BM may include a base material and a dye or pigment mixed with the base material. The bezel pattern BM is overlapped with the non-display region NDA illustrated in FIG. 1 and the bezel region BZA illustrated in FIG. 2. The bezel pattern BM may be disposed on a bottom surface of the base substrate BS. When the base substrate BS has a multi-layer structure, the bezel pattern BM may be interposed between interfaces defined by a plurality of layers. In an embodiment, the bezel pattern BM may be interposed between a thin film glass substrate and a protective film, for example. Although not illustrated separately, the window WM may further include at least one of a hard coating layer, an anti-fingerprint layer, and an anti-reflection layer on a top surface of the base substrate BS.

The upper member UM may include an upper film. The upper film may include a synthetic resin film. The synthetic resin film may include polyimide, polycarbonate, polyamide, triacetylcellulose, polymethylmethacrylate, or polyethylene terephthalate.

The upper film may absorb an external impact applied to the front surface of the display device DD. In an embodiment of the invention, the display module DM may include a color filter, which serves as an anti-reflective member and used in place of the polarizing film. Accordingly, the impact strength on the front surface of the display device DD may be reduced. The upper film may compensate for the reduced impact strength by applying the color filter.

The upper member UM is overlapped with the bezel region BZA (refer to FIG. 2) and the transmission region TA (refer to FIG. 2). The upper member UM may be overlapped with only a portion of the bezel region BZA. The portion of the bezel pattern BM may be exposed from the upper member UM. In an embodiment of the invention, the upper member UM may be omitted. In an embodiment of the invention, the upper member UM may be substituted into the optical film including the polarizer and the retarder.

Although not illustrated, an adhesive layer may be further interposed between the upper member UM and the window WM to bond the upper member UM to the window WM. The adhesive layer may be a pressure sensitive adhesive film ("PSA") or optically clear adhesive ("OCA").

The display module DM is disposed under the upper member UM. The display module DM is overlapped with the bezel region BZA and the transmission region TA. The display module DM may be fully overlapped with the upper member UM in the bezel region BZA. The side surface of the display module DM may be aligned in line with the side surface of the upper member UM. In a plan view, the edge of the display module DM may be aligned in line with the edge of the upper member UM.

The pad region PA of the display module DM may be overlapped with the upper member UM in the bezel region BZA. A portion, which corresponds to the pad region PA, of the display module DM may be bonded to the bottom surface of the upper member UM through the adhesive layer. As the pad region PA is overlapped with the upper member UM, and the portion, which is overlapped with the pad region PA, of the display module DM is bonded to the upper member UM, when the circuit board FCB is bonded to the pad region PA, the upper member UM may sufficiently support the pad region PA.

The lower member LM may include a lower film PF and a cover panel CP. In an embodiment, the lower member LM may further include a support plate and a digitizer.

The lower film PF may expose the pad region PA of the display module DM. The lower film PF may be smaller than the display module DM in size. In an embodiment, the lower film PF may be overlapped with only the display region DM-DA of the display module DM, for example. An open region PF-OP may be defined in the lower film PF to correspond to the non-display region DM-NDA. In an alternative embodiment, the lower film PF may have the size substantially corresponding to the display module DM. In this case, the open region PF-OP may be defined in the lower film PF to correspond to the pad region PA. The pad region PA may be exposed through the open region PF-OP.

The lower film PF may expose the pad region PA. The lower film PF may have an area smaller than an area of the display module DM. In an embodiment, the lower film PF may be overlapped with only the display region DM-DA, for example. The lower film PF may have an area substantially equal to an area of the display module DM. The open region PF-OP may be defined in the lower film PF to correspond to the pad region PA. The pad region PA may be exposed through the open region PF-OP.

The cover panel CP may be disposed under the lower film PF. The cover panel CP may increase resistance to compressive force generated from external pressure. Accordingly, the cover panel CP may serve to prevent deformation of the display panel DP. The cover panel CP may include a flexible plastic material such as polyimide or polyethylene terephthalate. In addition, the cover panel CP may be a colored film having a relatively low light transmittance. The cover panel CP may absorb light incident from the outside. In an embodiment, the cover panel CP may be a black synthetic resin film, for example. When the display device DD is viewed from the upper portion of the window WM, components arranged under the cover panel CP may not be viewed by the user.

Although not illustrated, a support plate may be further disposed under the cover panel CP. The support plate may include a metal material having a higher strength. The support plate may include a reinforced fiber composite. The support plate may include a reinforced fiber disposed inside the matrix part. The reinforced fiber may be carbon fiber or glass fiber. A matrix part may include a polymer resin. The matrix part may include a thermoplastic resin. In an embodiment, the matrix part may include a polyamide-based resin or a polypropylene-based resin, for example. In an embodiment, the reinforced fiber composite may be a carbon fiber reinforced plastic ("CFRP") or glass fiber reinforced plastic ("GFRP"), for example.

The main circuit board MCB may be provided on a bottom surface of the circuit board FCB. The circuit board FCB may include an insulating film and conductive lines disposed (e.g., mounted) on the insulating film. The main circuit board MCB may include signal lines and electronic devices which are not illustrated. The electronic devices may be connected to the signal lines to be electrically connected to the display module DM. The electronic devices generate various electrical signals, such as a signal for generating an image or a signal for sensing an external input, and process the sensed signal. A single main circuit board MCB may be provided to correspond to each electrical signal to be generated or processed. In an embodiment, at least three main circuit boards MCB may be provided, for example, but the invention is not limited to a particular embodiment.

Although not illustrated, the main circuit board MCB may include the driving chip DIC (refer to FIG. 2) disposed (e.g., mounted) in the main circuit board MCB.

Referring to FIGS. 2 and 3, the circuit board FCB is bonded onto a rear surface of the display module DM (rear surface bonding). The non-display region DM-NDA of the display module DM is not bent, thereby preventing the failure, which is caused when the non-display region DM-NDA of the display module DM is bent. In addition, the area of the bezel region BZA of the window WM to cover the non-display region DM-NDA of the display module DM may be reduced.

FIG. 4 is a cross-sectional view illustrating an embodiment of a display module according to the invention in brief.

Referring to FIG. 4, the display module DM may include the display panel DP and an input sensing layer ISL. The display panel DP may include a base layer BL, a circuit layer DP-CL, a display device layer DP-ED, and an encapsulating layer TFE.

The circuit layer DP-CL is disposed on a top surface of the base layer BL. The base layer BL may be a flexible substrate allowing bending, folding, or rolling. The base layer BL may be a glass substrate, a metal substrate, or a polymer substrate. However, the invention is not limited thereto, and the base layer BL may be an inorganic layer, an organic layer, or a composite material layer. Substantially, the base layer BL may have the shape the same as that of the display panel DP.

The base layer BL may have a multi-layer structure. In an embodiment, the base layer BL may include a first synthetic resin layer, a second synthetic resin layer, and inorganic layers disposed therebetween, for example. Each of the first and second synthetic resin layers may include a polyimide-based resin, but the invention is not particularly limited thereto.

The circuit layer DP-CL may be disposed on the base layer BL. The circuit layer DP-CL may include a plurality of insulating layers, a plurality of semiconductor patterns, a plurality of conductive patterns, and signal lines. The circuit layer DP-CL may include a driving circuit of a pixel. Hereinafter, unless otherwise specified, a component 'A' and a component 'B' may be disposed in the same layer, which is interpreted that the component 'A' and the component 'B' are formed in the same process, include the same material, or have the same stack structure. Conductive patterns or semiconductor patterns disposed in the same layer may be interpreted as described above.

The display device layer DP-ED may be disposed on the circuit layer DP-CL. The display device layer DP-ED may include a light-emitting element. In an embodiment, the light-emitting element may include an organic light-emitting material, an inorganic light-emitting material, an organic-inorganic light-emitting material, a quantum dot, a quantum rod, a micro-light emitting diode ("micro-LED"), or a nano-LED.

An encapsulating layer TFE may be disposed on the display device layer DP-ED. The encapsulating layer TFE may protect the display device layer DP-ED, that is, the light-emitting element from foreign substances such as moisture, oxygen, and dust particles. The encapsulating layer TFE may include at least one encapsulating inorganic layer. The encapsulating layer TFE may include the stack structure of a first encapsulating inorganic layer/encapsulating organic layer/a second encapsulating inorganic layer.

The input sensing layer ISL may be directly disposed on the display panel DP. The input sensing layer ISL may detect a user input using an electromagnetic induction method or a capacitive method, for example. The display panel DP and the input sensing layer ISL may be formed through a continuous process. In this case, the wording "~being directly disposed~" may indicate that a third component is not intervened between the input sensing layer ISL and the display panel DP. In other words, a separate adhesive layer is not interposed between the input sensing layer ISL and the display panel DP.

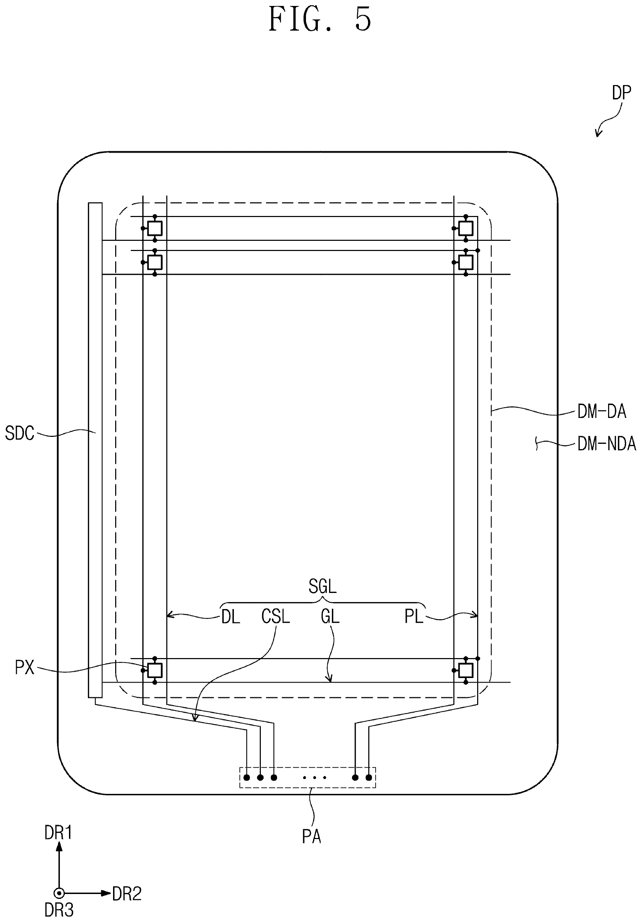

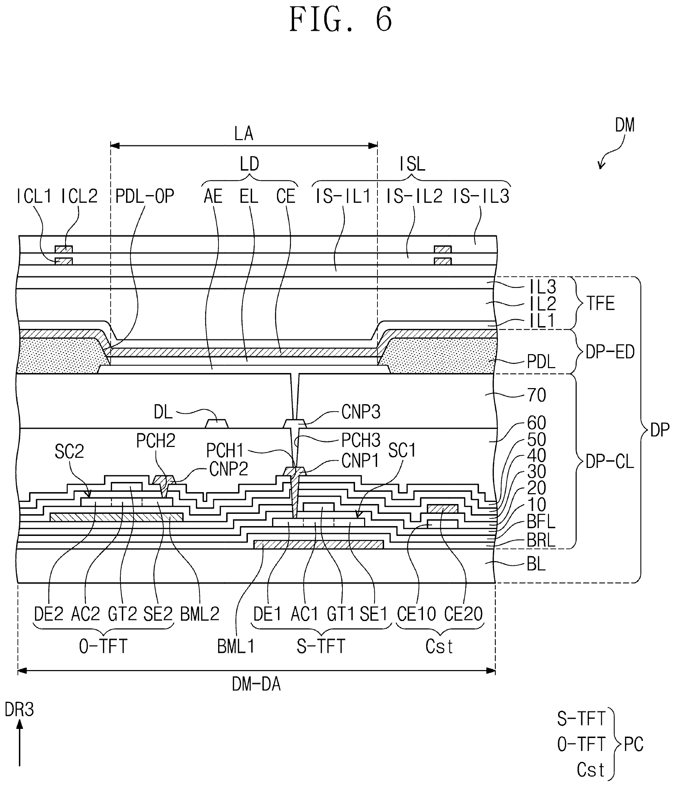

FIG. 5 is a cross-sectional view illustrating an embodiment of a display module according to the invention in brief. FIG. 6 is a cross-sectional view illustrating an embodiment of a display module according to the invention in brief.

As illustrated in FIG. 5, the display panel DP may include a scan driving circuit SDC, a plurality of signal lines SGL, and a plurality of pixels PX. The plurality of pixels PX are disposed in the display region DM-DA. Each of the pixels PX includes a light-emitting element and a pixel driving circuit connected thereto. The scan driving circuit SDC may include a plurality of signal lines SGL, and the pixel driving circuit may include the circuit layer DP-CL illustrated in FIG. 4.

The scan driving circuit SDC may include a gate driving circuit. The gate driving circuit generates a plurality of scan signals, and sequentially output the plurality of scan signals to a plurality of scan lines GL to be described later. The scan driving circuit SDC may further include a light-emitting driving circuit distinguished from a gate driving circuit. The light-emitting driving circuit may output the scan signals to the scan lines in another group.

The scan driving circuit SDC may include a plurality of thin film transistors formed through a process, such as relatively low temperature polycrystalline silicon ("LTPS") process or a relatively low temperature polycrystalline oxide ("LTPO") process, the same as that of the pixel driving circuit.

A plurality of signal lines SGL include scan lines GL, data lines DL, a power supply line PL, and a control signal line CSL. Each of the scan lines GL are connected to a relevant pixel PX among the pixels PX, and each of the data lines DL is connected to a relevant pixel PX among the pixels PX. The power supply line PL is connected to the plurality of pixels PX. The data lines DL may provide data signals to the pixels PX. The control signal line CSL may provide control signals to the scan driving circuit SDC.

A plurality of power supply lines PL may be provided. In an embodiment, the power supply line PL may include a first power supply line to receive a first power supply voltage, and a second power supply line to receive a second power supply voltage having a level higher than a level of the first power supply voltage, for example. The first power supply voltage is provided to the pixel PX through the first power supply line, and the second power supply voltage is provided to the pixels PX through the second power supply line. Although FIG. 5 illustrates that one control signal line CSL is provided, a plurality of control signal lines CSL may be provided.

The scan lines GL, the data lines DL, and the power supply line PL may be overlapped with the display region DM-DA and the non-display region DM-NDA, and the control signal line CSL may be overlapped with the non-display region DM-NDA. End portions of the plurality of signal lines SGL may be aligned in line with each other at one side of the non-display region DM-NDA. Although each of the plurality of signal lines SGL may be unitary, the each of the plurality of signal lines SGL may include a plurality of parts disposed in mutually different layers. Mutually different parts separated from each other by the insulating layer may be connected to each other through a contact hole defined through the insulating layer. In an embodiment, the data lines DL may include a first part disposed in the display region DM-DA, and a second part disposed in the non-display region DM-NDA and provided in a layer different from a layer for the first part, for example. The first part and the second part may include mutually different materials and may have mutually different stack structures.

The plurality of signal lines SGL may be electrically connected to the circuit board FCB illustrated in FIG. 3 through the pad region PA.

FIG. 6 illustrates a cross-sectional view of the display module DM corresponding to the pixel PX of FIG. 5.

The pixel driving circuit PC to drive the light-emitting element LD may include a plurality of driving elements. The pixel driving circuit PC may include a plurality of transistors S-TFT and O-TFT, and a capacitor Cst. The plurality of transistors S-TFT and O-TFT may include the silicon transistor S-TFT and the oxide transistor O-TFT. FIG. 6 illustrates the silicon transistor S-TFT and the oxide transistor O-TFT. The pixel driving circuit PC of FIG. 6 is provided only for the illustrative purpose, and the configuration of the pixel driving circuit PC is not limited thereto. The pixel driving circuit PC may include only one type transistor among the silicon transistor S-TFT and the oxide transistor O-TFT.

FIG. 6 illustrates the base layer BL in a single layer. The base layer BL may include synthetic resin such as polyimide. The base layer BL may be formed by coating a synthetic resin layer on a working substrate (or a carrier substrate). When the display module DM is completely formed through the subsequent processes, the working substrate may be removed.

Referring to FIG. 6, a first blocking electrode (or a blocking electrode) BML1 may be disposed on the base layer BL. The first blocking electrode BML1 may receive a bias voltage. The first blocking electrode BML1 may receive the first power supply voltage. The first blocking electrode BML1 may block electrical potential resulting from a polarization phenomenon from affecting the silicon transistor S-TFT. The first blocking electrode BML1 may block external light from reaching the silicon transistor S-TFT. The first blocking electrode BML1 in an embodiment of the invention may be a floating electrode isolated from another electrode or a line. The first blocking electrode BML1 may be disposed to correspond to the silicon transistor S-TFT. The first blocking electrode BML1 may include metal, e.g., molybdenum (Mo).

A barrier layer BRL may be disposed on the base layer BL and the first blocking electrode BML1. The barrier layer BRL may prevent foreign substances from being introduced from the outside. The barrier layer BRL may include at least one inorganic layer. The barrier layer BRL may include a silicon oxide layer and a silicon nitride layer. The silicon oxide layer may include a plurality of silicon oxide layers and the silicon nitride layer may include a plurality of silicon nitride layers, and the silicon oxide layers and the silicon nitride layers may be alternately stacked.

A buffer layer BFL may be disposed on the barrier layer BRL. The buffer layer BFL may prevent metal atoms or impurities from diffusing from the base layer BL to the first semiconductor pattern SC1 disposed on the base layer BL. The buffer layer BFL may include at least one inorganic layer. The buffer layer BFL may include a silicon oxide layer and a silicon nitride layer.

A first semiconductor pattern SC1 may be disposed on the buffer layer BFL. The first semiconductor pattern SC1 may include a silicon semiconductor. In an embodiment, the silicon semiconductor may include amorphous silicon, or polycrystalline silicon, for example. In an embodiment, the first semiconductor pattern may include low-temperature polysilicon, for example.

The first semiconductor pattern SC1 may have different electrical properties depending on whether the first semiconductor pattern SC1 is doped. The first semiconductor pattern SC1 may include a first region having higher conductivity and a second region having lower conductivity. The first region may be doped with N-type dopants or P-type dopants. A P-type transistor may include a doping region doped with the P-type dopant, and an N-type transistor may include a doping region doped with the N-type dopant. The second region may be an undoped region or may be doped at a concentration lower than that of the first region. In an embodiment, the first semiconductor pattern SC1 may be an N-type transistor.

The conductivity of the first region may be higher than the conductivity of the second region. The first region may substantially serve as an electrode or a signal line. The second region may actually correspond to a channel region (active region) of a transistor. In other words, a portion of the first semiconductor pattern SC1 may be a channel of a transistor, another portion of the first semiconductor pattern SC1 may be a source or a drain of the transistor, and another portion of the first semiconductor pattern SC1 may be a connection electrode or a connection signal line.

The source region SE1, a channel region AC1 (or the active region), and a drain region DE1 of the silicon transistor S-TFT may be formed from the first semiconductor pattern SC1. The source region SE1 and the drain region DE1 may extend in opposite directions from the channel region AC1, when viewed in a cross-sectional view.

A first insulating layer 10 may be disposed on the buffer layer BFL. The first insulating layer 10 may cover the first semiconductor pattern SC1. The first insulating layer 10 may be an inorganic layer. The first insulating layer 10 may be a single-layer silicon oxide layer. The inorganic layer of the circuit layer DP-CL to be described later as well as the first insulating layer 10 may have a single-layer structure or a multi-layer structure, and may include at least one of the above-described materials, but the invention is not limited thereto.

A gate GT1 (or a gate electrode) of the silicon transistor S-TFT is disposed on the first insulating layer 10. The gate GT1 may be a portion of the metal pattern. The gate GT1 is overlapped with the channel region AC1. In the process of doping the first semiconductor pattern SC1, the gate GT1 may be a mask. A first electrode CE10 of the storage capacitor (or the capacitor) Cst is disposed on the first insulating layer 10. Unlike illustrated in FIG. 6, the first electrode CE10 may have an integral shape with the gate GT1.

The second insulating layer 20 may be disposed on the first insulating layer 10 and may cover the gate GT1. In an embodiment of the invention, an upper electrode overlapped with the gate GT1 may be further disposed on the second insulating layer 20. A second electrode CE20 overlapped with the first electrode CE10 may be disposed on the second insulating layer 20. The upper electrode and the second electrode CE20 may have the integral form in a plan view.

A second blocking electrode BML2 is disposed on the second insulating layer 20. The second blocking electrode BML2 may be disposed to correspond to the oxide transistor O-TFT. In an embodiment of the invention, the second blocking electrode BML2 may be omitted. In an embodiment of the invention, the first blocking electrode BML1 may extend to the lower portion of the oxide transistor O-TFT such that the second blocking electrode BML2 is replaced with the first blocking electrode BML1.

A third insulating layer 30 may be disposed on the second insulating layer 20. A second semiconductor pattern SC2 may be disposed on the third insulating layer 30. The second semiconductor pattern SC2 may include a channel region AC2 of the oxide transistor O-TFT. The second semiconductor pattern SC2 may include a metal oxide semiconductor. The second semiconductor pattern SC2 may include a transparent conductive oxide ("TCO") such as indium tin oxide ("ITO"), indium zinc oxide ("IZO"), indium gallium zinc oxide ("IGZO"), zinc oxide (ZnOx), or indium oxide (In₂O₃).

The metal oxide semiconductor may include a plurality of regions SE2, AC2, and DE2 classified according to whether a transparent conductive oxide is reduced. The region (hereinafter, also referred to as the reduced region), in which the transparent conductive oxide is reduced, has greater conductivity than that of a region (hereinafter, also referred to as the non-reduced region) in which the transparent conductive oxide is not reduced. The reduced region substantially serves as a source/drain or signal line of a transistor. The non-reduced region actually corresponds to a semiconductor region (or a channel region) of a transistor. In other words, a partial region of the second semiconductor pattern SC2 may be a semiconductor region of the transistor, another partial region of the second semiconductor pattern SC2 may be the source region SE2/drain region DE2 of the transistor, and another portion of the second semiconductor pattern SC2 may be a region for transmitting a signal.

A fourth insulating layer 40 may be disposed on the third insulating layer 30. As illustrated in FIG. 6, the fourth insulating layer 40 may cover the second semiconductor pattern SC2. In an embodiment of the invention, the fourth insulating layer 40 may be an insulating pattern which is overlapped with the gate GT2 of the oxide transistor O-TFT and exposes the source region SE2 and the drain region DE2 of the oxide transistor O-TFT.

The gate GT2 of the oxide transistor O-TFT is disposed on the fourth insulating layer 40. The gate GT2 of the oxide transistor O-TFT may be a portion of a metal pattern. The gate GT2 of the oxide transistor O-TFT is overlapped with the channel region AC2.

A fifth insulating layer 50 may be disposed on the fourth insulating layer 40, and the fifth insulating layer 50 may cover the gate GT2. Each of the first to fifth insulating layers 10 to 50 may be an inorganic layer.

A conductive layer may be disposed on the fifth insulating layer 50. According to the invention, the conductive layer include a first connection pattern CNP1 and a second connection pattern CNP2. Since the first connection pattern CNP1 and the second connection pattern CNP2 are formed through the same process, the first connection pattern CNP1 and the second connection pattern CNP2 may have the same material and the same stack structure. The first connection pattern CNP1 may be connected to the drain region DE1 of the silicon transistor S-TFT through a first pixel contact hole PCH1 formed through the first to fifth insulating layers 10, 20, 30, 40, and 50. The second connection pattern CNP2 may be connected to the source region SE2 of the oxide transistor O-TFT through a second pixel contact hole PCH2 formed through the fourth and fifth insulating layers 40 and 50. The connection relationship between the first connection pattern CNP1 and the second connection pattern CNP2 with respect to the silicon transistor S-TFT and the oxide transistor O-TFT is not necessarily limited thereto.

A sixth insulating layer 60 may be disposed on the fifth insulating layer 50. A third connection pattern CNP3 may be disposed on the sixth insulating layer 60. The third connection pattern CNP3 may be connected to the first connection pattern CNP1 through a third pixel contact hole PCH3 formed through the sixth insulating layer 60. The data line DL may be disposed on the sixth insulating layer 60. A seventh insulating layer 70 may be disposed on the sixth insulating layer 60 to cover a third connection pattern CNP3 and the data line DL. The third connection pattern CNP3 and the data line DL may be formed through the same process. Accordingly, the third connection pattern CNP3 and the data line DL may have the same material and the same stack structure. Each of the sixth and seventh insulating layers 60 to 70 may be an organic layer.

The first blocking electrode BML1, the gate GT1 of the silicon transistor S-TFT, the second electrode CE20, and the gate GT2 of the oxide transistor O-TFT may include molybdenum (Mo) having excellent heat resistance, the alloy including or consisting of molybdenum (Mo), titanium (Ti), or an alloy including or consisting of titanium (Ti). The first connection pattern CNP1 and the second connection pattern CNP2 may include aluminum having higher electrical conductivity. The first connection pattern CNP1 and the second connection pattern CNP2 may have a three-layer structure in which titanium/aluminum/titanium are stacked.

The light-emitting element LD may include an anode AE (or a first electrode), a light-emitting layer EL, and a cathode CE (or a second electrode). The anode AE of the light-emitting element LD may be disposed on the seventh insulating layer 70. The anode AE may be a transmission electrode, a transflective electrode, or a reflective electrode. The anode AE may include the stack structure having ITO/Ag/ITO sequentially stacked. The positions of the anode AE and the cathode CE may be exchanged.

A pixel defining layer PDL may be disposed on the seventh insulating layer 70. In addition, the pixel defining layer PDL may include an organic material. The pixel defining layer PDL may have a property of absorbing light. In an embodiment, the pixel defining layer PDL may have a black color, for example. The pixel defining layer PDL may include a black coloring agent. The black coloring agent may include a black dye and a black pigment. The black coloring agent may include carbon black, metal, such as chromium, or oxides thereof. The pixel defining layer PDL may correspond to a light-blocking pattern having a light-blocking property.

The pixel defining layer PDL may cover a portion of the anode AE. In an embodiment, an opening PDL-OP to expose the portion of the anode AE may be defined in the pixel defining layer PDL, for example. A light-emitting region LA may be defined to correspond to the opening PDL-OP. In an embodiment of the invention, a hole control layer may be interposed between the anode AE and the light-emitting layer EL. The hole control layer may include a hole transport layer, and may further include a hole injection layer. An electron control layer may be interposed between the light-emitting layer EL and the cathode CE. The electron control layer may include an electron transport layer, and may further include an electron injection layer.

The encapsulating layer TFE may cover the light-emitting element LD. The encapsulating layer TFE may include a first encapsulating insulating layer IL1, a second encapsulating insulating layer IL2, and a third encapsulating insulating layer IL3. However, the invention is not limited thereto, and the encapsulating layer TFE may further include a plurality of inorganic layers and organic layers.

The first encapsulating insulating layer IL1 may be an inorganic layer. The first encapsulating insulating layer IL1 may prevent external moisture or oxygen from being infiltrated into the light-emitting element LD. In an embodiment, the first encapsulating insulating layer IL1 may include silicon nitride, silicon oxide, or any combinations thereof, for example. The first encapsulating insulating layer IL1 may be formed through a chemical vapor deposition process.

The second encapsulating insulating layer IL2 may be an organic layer. The second encapsulating insulating layer IL2 may be disposed on the first encapsulating insulating layer IL1 to contact the first encapsulating insulating layer IL1. The second encapsulating insulating layer IL2 may provide a flat surface on the first encapsulating insulating layer IL1. The roughness formed on a top surface of the first encapsulating insulating layer IL1 or particles on the first encapsulating insulating layer IL1 are covered by the second encapsulating insulating layer IL2, thereby preventing a surface state of the top surface of the first encapsulating insulating layer IL1 from exerting an influence on components formed on the second encapsulating insulating layer IL2. In addition, the second encapsulating insulating layer IL2 may mitigate the stress between layers contacting each other. The second encapsulating insulating layer IL2 may be formed through a solution process such as a spin coating process, a slit coating process, or an inkjet process.

The third encapsulating insulating layer IL3 may be disposed on the second encapsulating insulating layer IL2 to cover the second encapsulating insulating layer IL2. The third encapsulating insulating layer IL3 may be stably formed on a flatter surface, as compared to that the third encapsulating insulating layer IL3 is disposed on the first encapsulating insulating layer IL1. The third encapsulating insulating layer IL3 may encapsulate moisture discharged from the second encapsulating insulating layer IL2, thereby preventing the moisture from flowing out.

The third encapsulating insulating layer IL3 may be optically transparent. In an embodiment, the third encapsulating insulating layer IL3 may have a visible light transmittance of about 90% or more, for example. The third encapsulating insulating layer IL3 may have a light transmittance higher than that of the first encapsulating insulating layer IL1. The third encapsulating insulating layer IL3 may be an inorganic layer. The third encapsulating insulating layer IL3 may include silicon oxide (SiOₓ) or silicon oxynitride (SiO_{N}). The third encapsulating insulating layer IL3 may be formed through a chemical vapor deposition process. Each of the first encapsulating insulating layer IL1, the second encapsulating insulating layer IL2, and the third encapsulating insulating layer IL3 may include a plurality of layers, and the invention is not limited to a particular embodiment.

The input sensing layer ISL may include at least one conductive layer (or at least one sensor conductive layer) and at least one insulating layer (or at least one sensor insulating layer). In an embodiment, the input sensing layer ISL may include a first insulating layer IS-IL1, a first conductive layer ICL1, a second insulating layer IS-IL2, a second conductive layer ICL2, and a third insulating layer IS-IL3. FIG. 6 illustrates a conductive line of the first conductive layer ICL1 and a conductive line of the second conductive layer ICL2 in brief.

The first insulating layer IS-IL1 may be directly disposed on the display panel DP. The first insulating layer IS-IL1 may be an inorganic layer including at least any one of silicon nitride, silicon oxynitride, and silicon oxide. Each of the first conductive layer ICL1 and the second conductive layer ICL2 may have a single-layer structure or a multi-layer structure stacked in the third direction DR3. The first conductive layer ICL1 and the second conductive layer ICL2 may include conductive lines defining the electrode in a mesh form. The conductive line of the first conductive layer ICL1 and the conductive line of the second conductive layer ICL2 may be connected to each other or may not be connected to each other through a contact hole defined through the second insulating layer IS-IL2. The connection relationship between the conductive line of the first conductive layer ICL1 and the conductive line of the second conductive layer ICL2 may be determined depending on the type of sensor formed by the input sensing layer ISL.

The first conductive layer ICL1 and the second conductive layer ICL2 having a single-layer structure may include a metal layer or a transparent conductive layer. The metal layer may include molybdenum (Mo), silver (Ag), titanium (Ti), copper (Cu), aluminum (Al), or any alloys thereof. The transparent conductive layer may include a transparent conductive oxide, such as indium tin oxide ("ITO"), indium zinc oxide ("IZO"), zinc oxide (ZnOx), or indium zinc tin oxide ("IZTO"). In addition, the transparent conductive layer may include a conductive polymer, such as poly(3,4-ethylenedioxythiophene) ("PEDOT"), a metal nanowire, or graphene.

The first conductive layer ICL1 and the second conductive layer ICL2 having a multi-layer structure may include a metal layer. The metal layers may have a three-layer structure of titanium/aluminum/titanium, for example. The conductive layer in the multi-layer structure may include at least one metal layer and at least one transparent conductive layer. The second insulating layer IS-IL2 may be interposed between the first conductive layer ICL1 and the second conductive layer ICL2. The third insulating layer IS-IL3 may cover the second conductive layer ICL2. In an embodiment of the invention, the third insulating layer IS-IL3 may be omitted. The second insulating layer IS-IL2 and the third insulating layer IS-IL3 may include an inorganic layer or an organic layer.

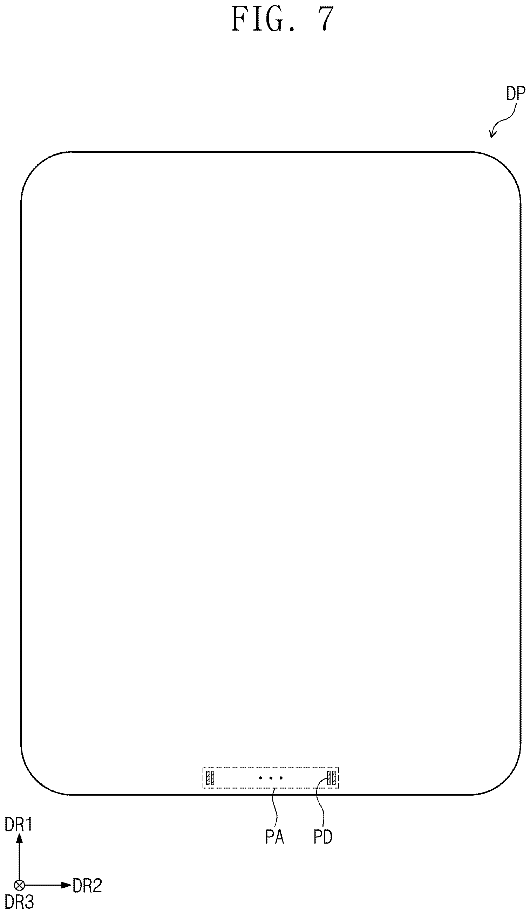

FIG. 7 is a plan view of an embodiment of a display panel according to the invention. Specifically, FIG. 7 is a plan view that the display panel DP is viewed in the third direction DR3.

Referring to FIG. 7, a pad electrode PD may be disposed on a rear surface of the display panel DP. Specifically, the pad electrode PD may be disposed in the pad region PA. A plurality of pad electrodes PD may be provided. The pad electrodes PD may be arranged in the second direction DR2.

The plurality of signal lines SGL (refer to FIG. 5) disposed on the display panel DP may be electrically connected to the circuit board FCB of illustrated in FIG. 3 through the pad region PA. In an embodiment, the plurality of signal lines SGL may be connected to the pad electrodes PD, which are disposed in the pad region PA and spaced apart from each other in the first direction DR1, through the connection electrodes, or the like, for example. Although not illustrated, the pad electrodes PD may be disposed on the rear surface of the display panel DP and may be electrically connected to the circuit board FCB (refer to FIG. 2).

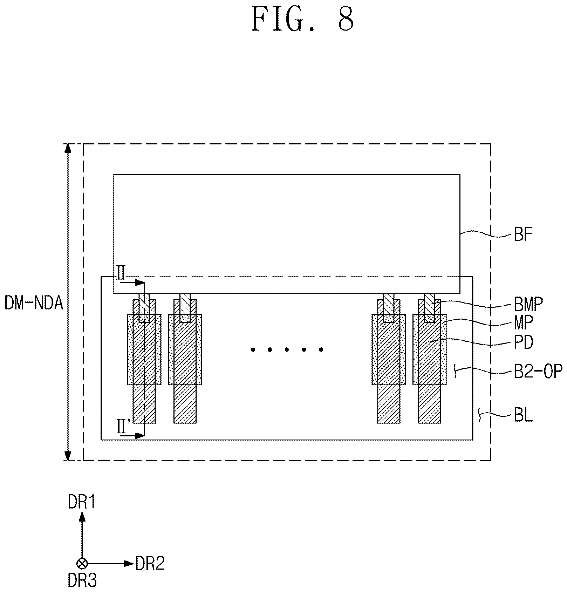

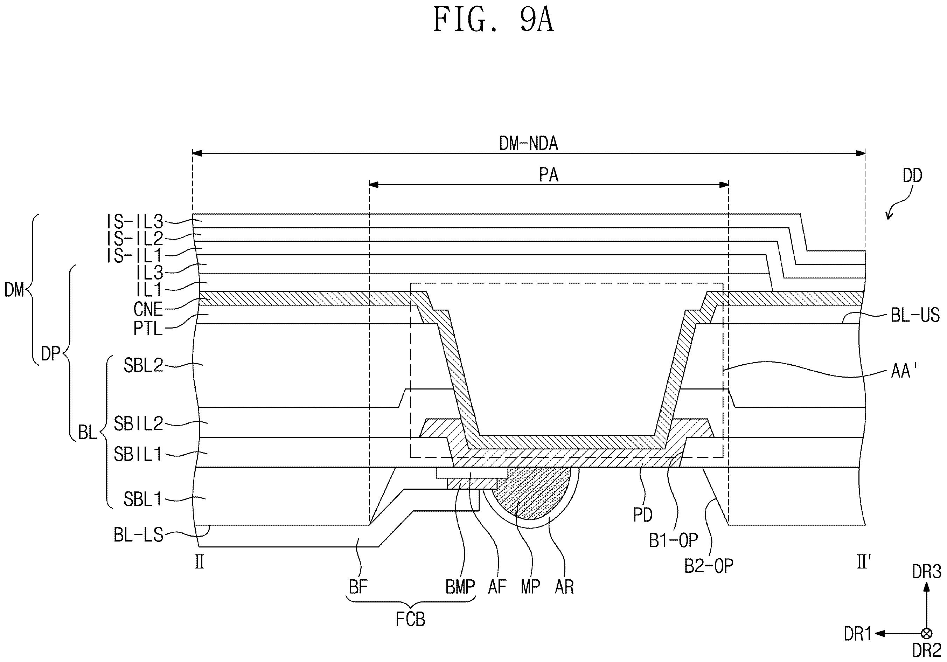

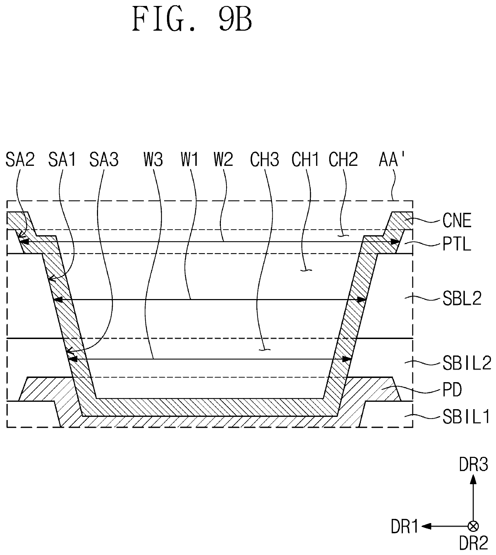

FIG. 8 is an enlarged view of an embodiment of a portion of a display device according to the invention. FIG. 9A is a cross-sectional view of a portion of a display device taken along line II-II' of FIG. 8. FIG. 9B is an enlarged view of a region AA' illustrated in FIG. 9A. FIGS. 8 and 9A are views illustrating a state in which the circuit board FCB is attached to the display panel DP. Hereinafter, the duplication of the above description will be omitted.

Referring to FIGS. 8 and 9A, the display device DD of the invention may include a plurality of pad electrodes PD. The pad electrodes PD and the first blocking electrode BML1 illustrated in FIG. 6 may be disposed in the same layer. The pad electrodes PD and the first blocking electrode BML1 may be formed through the same process. In an embodiment, a single metal layer may be disposed on the base layer BL, the metal layer may be patterned to form pad electrodes PD in the non-display region DM-NDA, and the first blocking electrode BML1 may be formed in the display region DM-DA, for example. Although not illustrated, the pad electrodes PD may be electrically connected to the data line DL illustrated in FIG. 5 through a connection electrode CNE disposed on the pad electrodes PD.

The pad electrodes PD may extend in the first direction DR1 and may be arranged in the second direction DR2. In other words, the pad electrodes PD may be located in a plane defined by the first and second direction DR1, DR2. However, the invention is not limited thereto. The shape and arrangement of the pad electrodes PD are not limited to the drawing. The pad electrodes PD may be overlapped with the non-display region DM-NDA. In an embodiment, the pad electrodes PD may be disposed in the pad region PA, for example. The pad electrodes PD may be exposed to the outside through a first surface (or bottom surface) BL-LS of the base layer BL for back-bonding with the circuit board FCB. However, the invention is not limited thereto, and the pad electrodes PD may be exposed to the outside through the contact hole, instead of being directly exposed to the outside. The first surface BL-LS of the base layer BL faces a second surface (or upper surface) BL-US of the base layer BL in the third direction DR3.

The base layer BL may include a first sub-base layer (or a first base layer) SBL1, a first sub-base inorganic layer (also referred to as a first sub-base insulating layer) SBIL1, a second sub-base inorganic layer (also referred to as a second sub-base insulating layer) SBIL2, and a second sub-base layer (or a second base layer) SBL2, which are sequentially stacked. In the description, the first sub-base inorganic layer SBIL1 and the second sub-base inorganic layer SBIL2 together may be referred to as a base insulating layer. The first sub-base inorganic layer SBIL1 is disposed on the first sub-base layer SBL1, the second sub-base inorganic layer SBIL2 is disposed on the first sub-base inorganic layer SBIL1, and the second sub-base layer SBL2 is disposed on the second sub-base inorganic layer SBIL2. Part of the pad electrodes PD may be located between the first sub-base inorganic layer SBIL1 and the second sub-base inorganic layer SBIL2.

In an embodiment of the invention, the first sub-base layer SBL1 and the second sub-base layer SBL2 may include an organic material or a synthetic resin material, e.g., polyimide. The first sub-base inorganic layer SBIL1 and the second sub-base inorganic layer SBIL2 may include an inorganic material. In an embodiment, the first sub-base inorganic layer SBIL1 and the second sub-base inorganic layer SBIL2 may include silicon nitride, silicon oxy nitride, or silicon oxide, for example. The amorphous silicon may include amorphous silicon (a-Si). Each of the first sub-base inorganic layer SBIL1 and the second sub-base inorganic layer SBIL2 may include a plurality of layers.

The first surface BL-LS of the base layer BL is provided on the first sub-base layer SBL1, and a second opening B2-OP is defined in the first sub-base layer SBL1 to expose the pad electrodes PD out of the display module DM. A second opening B2-OP may expose a portion of the first sub-base inorganic layer SBIL1 to the outside. A first opening (also referred to as a base opening) B1-OP is defined in the first sub-base inorganic layer SBIL1 such that a portion of the pad electrodes PD is disposed in the first opening B1-OP. The size of the second opening B2-OP may be greater than the size of the first opening B1-OP. In particular, the connection electrode CNE may not contact the first sub-base inorganic layer SBIL1 at the first opening B1-OP.

The width of the second opening B2-OP in the first direction DR1 may gradually decrease in the third direction DR3. However, the invention is not limited thereto. In an embodiment, the width of the second opening B2-OP in the first direction DR1 may be constant in the third direction DR3, for example. As illustrated, the pad electrodes PD may be disposed in the first opening B1-OP. The pad electrodes PD may be embedded in the base layer BL. However, the invention is not limited thereto. In an embodiment, the pad electrodes PD may be disposed on the first surface BL-LS of the base layer BL, for example.

A protective layer PTL may be disposed on the base layer BL. In an embodiment, the protective layer PTL may be disposed while directly contacting the second sub-base layer SBL2, for example. The protective layer PTL may be overlapped with at least a portion of the second sub-base layer SBL2. The thickness of the protective layer PTL may be smaller than the thickness of the second sub-base layer SBL2. In an embodiment of the invention, the protective layer PTL may include at least one inorganic layer. In an embodiment, the inorganic layer may include silicon nitride, silicon oxy nitride, or silicon oxide, for example. The amorphous silicon may include amorphous silicon (a-Si).

Referring to FIGS. 9A and 9B together, the connection electrode CNE may be electrically connected to the pad electrodes PD through contact holes CH1, CH2, and CH3. In an embodiment, the contact holes CH1, CH2, and CH3 may include the first contact hole CH1, the second contact hole CH2, and the third contact hole CH3, for example. The first contact hole CH1 is formed through the second sub-base layer SBL2, the second contact hole CH2 is formed through the protective layer PTL, and the third contact hole CH3 may be formed in the first sub-base inorganic layer SBIL1 through the second sub-base inorganic layer SBIL2. The connection electrode CNE may cover side surfaces of the contact holes CH1, CH2, and CH3 to connect the pad electrodes PD.

The first contact hole CH1 is defined by a first side surface SA1 of the second sub-base layer SBL2, and a first width W1 of the first contact hole CH1 may be defined as a distance between first side surfaces SA1. The second contact hole CH2 is defined by a second side surface SA2 of the protective layer PTL, and a second width W2 of the second contact hole CH2 may be defined as a distance between second side surfaces SA2. The third contact hole CH3 is defined by the third side surface SA3 of the second sub-base inorganic layer SBIL2, and a third width W3 of the third contact hole CH3 may be defined as a distance between third side surfaces SA3.

In an embodiment of the invention, the first width W1 of the first contact hole CH1 may be different from the second width W2 of the second contact hole CH2. In an embodiment, the second width W2 may be greater than the first width W1. In the process of forming the first contact hole CH1 and the second contact hole CH2, the protective layer PTL and the second sub-base layer SBL2 may have different etching rates, for example. Accordingly, the first width W1 and the second width W2 may be different from each other. In an alternative embodiment, after the protective layer PTL may be first etched, the second sub-base layer SBL2 may be etched, such that the first width W1 and the second width W2 may be different from each other. As illustrated, the third width W3 may be smaller than the first width W1. However, the invention is not limited thereto. In an embodiment, the third width W3 may be equal to the first width W1, for example. In other words, the first side surface SA1 and the third side surface SA3 may be aligned in line with each other, in the third direction DR3.

The second contact hole CH2 may be formed after the protective layer PTL is disposed on the second sub-base layer SBL2. In other words, the second contact hole CH2 may be formed simultaneously with the first contact hole CH1, or may be formed after the first contact hole CH1 is formed. When the first contact hole CH1 is formed, the operation of etching the second sub-base layer SBL2 including the organic material may be included. In the operation of etching the second sub-base layer SBL2, outgas may be emitted to degrade display quality of the display device DD. In an embodiment of the invention, the second sub-base layer SBL2 is etched after the protective layer PTL including at least one inorganic layer is disposed on the second sub-base layer SBL2, thereby reducing the outflow of the outgas which is emitted. Accordingly, the display device DD improved in display quality may be provided.

In an embodiment of the invention, the first to fifth insulating layers 10 to 50 and the conductive layers CNP1, CNP2, and BML2 illustrated in FIG. 6 may not be formed in the pad region PA. Although not illustrated, a photoresist is disposed before the protective layer PTL is formed. Accordingly, the first to fifth insulating layers 10 to 50 and the conductive layers CNP1, CNP2, and BML2 may not be formed between the second sub-base layer SBL2 and the protective layer PTL. In an alternative embodiment, the photoresist is disposed before the connection electrode CNE is formed. Accordingly, the first to fifth insulating layers 10 to 50 and the conductive layers CNP1, CNP2, and BML2 may not be formed between the connection electrode CNE and the protective layer PTL. Accordingly, the connection electrode CNE may be directly disposed on the first to third side surfaces SA1, SA2, and SA3 without a step difference. Accordingly, the connection electrode CNE may be prevented from being disconnected due to the step difference, thereby preventing the connection failure between the connection electrode CNE and the pad electrodes PD from being caused by residues from the first to fifth insulating layers 10 to 50 and the conductive layers CNP1, CNP2, and BML2. Accordingly, the display device DD improved in reliability may be provided.

The first contact hole CH1, the second contact hole CH2, and the third contact hole CH3 may be overlapped with each other in a plan view. In addition, the first to third contact holes CH1, CH2, and CH3 may be overlapped with the first opening B1-OP and the second opening B2-OP in a plan view. As illustrated in the drawing, the width of the second opening B2-OP is formed to be greater than each of the first to third widths W1, W2, and W3, but the invention is not limited thereto. In an embodiment, the width of the second opening B2-OP may be smaller than each of the first to third widths W1, W2, and W3, for example.

Referring back to FIG. 8 and FIG. 9A, the circuit board FCB may be attached to the display panel DP while being bent on the rear surface of the display panel DP. An adhesive layer may be interposed between the circuit board FCB and the first surface BL-LS of the base layer BL. The circuit board FCB may be fixed to the first surface BL-LS of the base layer BL by the adhesive layer.

The circuit board FCB may include a base film BF and a bump electrode BMP disposed on the base film BF. The base film BF may be unitary and electrically connected to a plurality of bump electrodes BMP. In this case, a plurality of lines may be included in the base film BF. However, the invention is not limited thereto. The base film BF may only be attached to the plurality of bump electrodes BMP and may not be electrically connected to the plurality of bump electrodes BMP. In this case, the base film BF may include a synthetic resin material, e.g., polyimide. The bump electrodes BMP may be disposed on the base film BF.

The bump electrodes BMP may be in a non-overlap state with the pad electrodes PD, in a plan view. The bump electrodes BMP may be electrically connected to the pad electrodes PD. The bump electrodes BMP may be formed to correspond to the pad electrodes PD. In other words, one bump electrode BMP may correspond to one pad electrode PD. The bump electrodes BMP may extend in the first direction DR1 and may be arranged in the second direction DR2. The planar area of the pad electrodes PD may be greater than the planar area of the bump electrodes BMP.

The adhesive layer AF may be disposed between the base film BF and the pad electrodes PD. In an embodiment of the invention, the adhesive layer AF may include a non-conductive material. In an embodiment, the adhesive layer AF may include a non-conductive film, for example.

The bump electrodes BMP may be electrically connected to the pad electrodes PD. In detail, the display device DD (refer to FIG. 2) according to the invention may further include metal patterns MP for electrically connecting the bump electrodes BMP to the pad electrodes PD. The metal patterns MP may be disposed on the pad electrodes PD and the bump electrodes BMP to electrically connect the pad electrodes PD to the bump electrodes BMP. The metal patterns MP may be provided in a number corresponding to each of the pad electrodes PD and the bump electrodes BMP.

Each of the metal patterns MP may be a pattern formed by curing metal ink. The metal patterns MP may include a solder paste. The metal patterns MP may be formed using a metal ink including silver or copper. The metal patterns MP may be formed by curing and then patterning the metal ink. The metal pattern MP may be formed at a relatively low temperature, and may electrically connect and bond the pad electrodes PD to the bump electrodes BMP without a process of pressing at a relatively high temperature.

The display device DD according to the invention may further include adhesive resin AR. The adhesive resin AR may include an optical clear resin. However, a material of the adhesive resin AR is not limited thereto, and may include a general adhesive agent or adhesion agent. In an embodiment, the adhesive resin AR may include a pressure sensitive adhesive ("PSA"), or an optical clear adhesive ("OCA"), for example. The adhesive resin AR may cover the metal pattern MP exposed to the outside. Unlike FIG. 9A, the adhesive resin AR may be formed to fill the second opening B2-OP. The adhesive resin AR is formed to contact a side surface of the first sub-base layer SBL1, thereby reducing the probability in which the inner part of the display device DD is cracked, when the display device DD receives an impact from the outside and is bent around the second opening B2-OP.

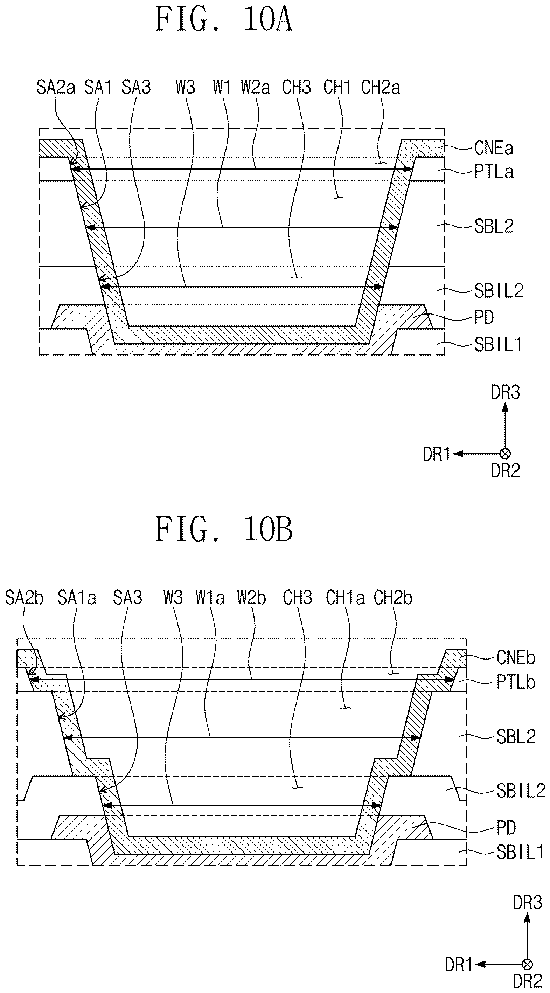

FIGS. 10A and 10B are enlarged views of an embodiment of a portion of a display device according to the invention. In the following description, the duplication of the above description will be omitted.

Referring to FIG. 10A, a connection electrode CNEa may be electrically connected to the pad electrodes PD through the contact holes CH1, CH2a, and CH3. The first contact hole CH1 is defined by the first side surface SA1 of the second sub-base layer SBL2, and the first width W1 of the first contact hole CH1 may be defined as the distance between the first side surfaces SA1. A second contact hole CH2a is defined by a second side surface SA2a of a protective layer PTLa, and a second width W2a of the second contact hole CH2a may be defined as the distance between second side surfaces SA2a. The third contact hole CH3 is defined by the third side surface SA3 of the second sub-base inorganic layer SBIL2, and the third width W3 of the third contact hole CH3 may be defined as the distance between the third side surfaces SA3.

As illustrated, the first width W1 may be smaller than the second width W2a, and the third width W3 may be smaller than the first width W1. However, the invention is not limited thereto, and the first width W1, the second width W2a, and the third width W3 may be equal to each other. In other words, the first side surface SA1, the second side surface SA2a, and the third side surface SA3 may be aligned in line with each other in the third direction DR3. Accordingly, the connection electrode CNEa may be disposed on the first side surface SA1, the second side surface SA2a, and the third side surface SA3 without the step difference, thereby preventing the connection electrode CNEa from being disconnected by the first side surface SA1, the second side surface SA2a, and the third side surface SA3.

Referring to FIG. 10B, a connection electrode CNEb may be electrically connected to the pad electrodes PD through contact holes CH1a, CH2b, and CH3. A first contact hole CH1a may be defined by a first side surface SA1a of the second sub-base layer SBL2, and a first width W1a of the first contact hole CH1a may be defined as the distance between first side surfaces SA1a. A second contact hole CH2b may be defined by a second side surface SA2b of a protective layer PTLb, and a second width W2b of the second contact hole CH2b may be defined as the distance between second side surfaces SA2b. The third contact hole CH3 may be defined by the third side surface SA3 of the second sub-base inorganic layer SBIL2, and a third width W3 of the third contact hole CH3 may be defined as the distance between the third side surfaces SA3.

In the process for manufacturing the display device DD (refer to FIG. 2) according to the invention, the protective layer PTLb, the second sub-base layer SBL2, and the second sub-base inorganic layer SBIL2 may be sequentially etched so that the first width W1a of the second sub-base layer SBL2 is be smaller than the second width W2b of the protective layer PTLb and the third width W3 of the second sub-base inorganic layer SBIL2 is smaller than the first width W1a of the second sub-base layer SBL2. Accordingly, the protective layer PTLb, the second sub-base layer SBL2, and the second sub-base inorganic layer SBIL2 may be prevented from being inversely tapered due to the difference in etching rate among the protective layer PTLb, the second sub-base layer SBL2, and the second sub-base inorganic layer SBIL2. Accordingly, the connection electrode CNEb may be prevented from being disconnected by the first side surface SA1a, the second side surface SA2b, and the third side surface SA3.

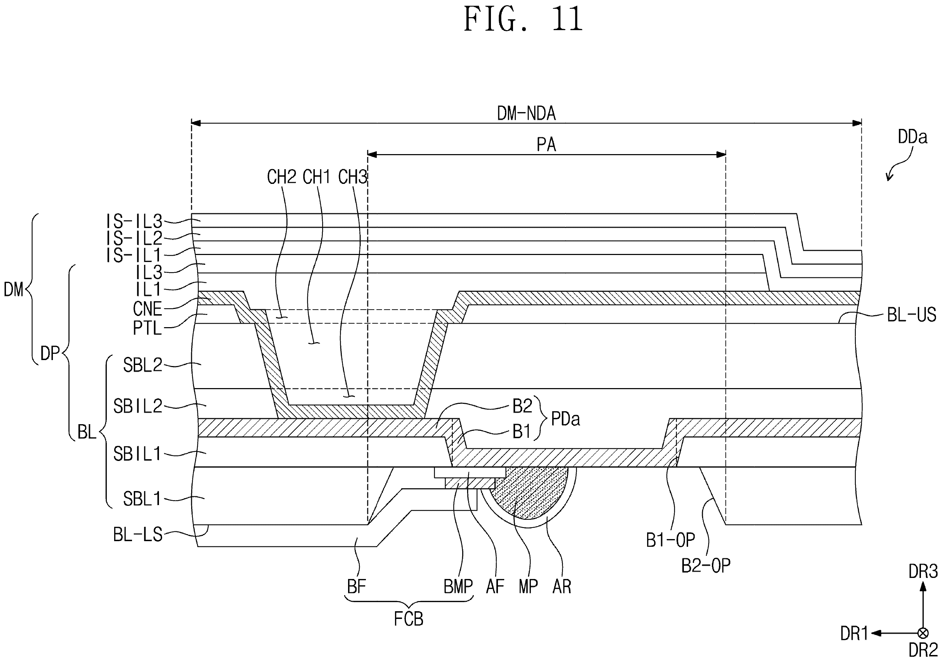

FIG. 11 is a cross-sectional view of a portion of an embodiment of a display device DDa according to the invention.

Referring to FIG. 11, a pad electrodes PDa may include a first part B1 overlapped with the first opening B1-OP and a second part B2, which is in a non-overlap state with the first opening B1-OP. The second part B2 may be directly disposed on the first sub-base inorganic layer SBIL1. The second part B2 may contact an upper surface and a side surface of the first sub-base inorganic layer SBIL1. The first part B1 may be disposed in the pad region PA. The first part B1 may be disposed in the first opening B1-OP. The first part B1 may be exposed to the outside by the second opening B2-OP. The second part B2 may extend in the first direction DR1 from the first part B1. The first part B1 and the second part B2 may be formed integrally with each other. In other words, the pad electrodes PDa with a first and second part B1, B2 may cover the first sub-base inorganic layer SBIL1 and cover the first opening B1-OP. In particular, the first and second part B1, B2 may extend in a first direction, wherein the first part B1 may be located in another plane or another layer than the second part B2.

Each of the first to third contact holes CH1, CH2, and CH3 may not overlap the first opening B1-OP. In an embodiment of the invention, a connection electrode CNE may directly contact the second part B2 which is in the non-contact state with the first opening B1-OP. The connection electrode CNE may be electrically connected to the second part B2 to be electrically connected to the pad electrodes PDa. Each of the first to third contact holes CH1, CH2, and CH3 may be partially overlapped with the second opening B2-OP, in a plan view. However, each of the first to third contact holes CH1, CH2, and CH3 may be in the non-overlap state with the second opening B2-OP, when in a plan view, when is different from the drawings.

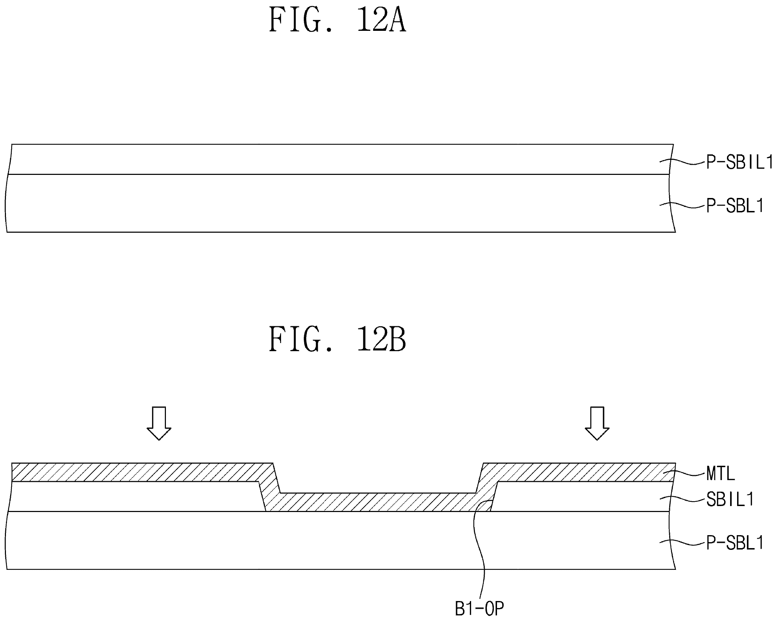

FIGS. 12A to 12H are views illustrating an embodiment of one operation in a method for manufacturing a display device. In the following description about the method for manufacturing the display device in an embodiment of the invention with reference to FIGS. 12A to 12H, the same reference numerals will be assigned to components the same as components described above, and the details thereof will be omitted.

Referring to FIG. 12A, the operation of forming a first preliminary sub-base layer P-SBL1 (also referred to as a first preliminary base layer) and the operation of forming a first preliminary sub-base inorganic layer P-SBIL1 on the first preliminary sub-base layer P-SBL1 may be performed.

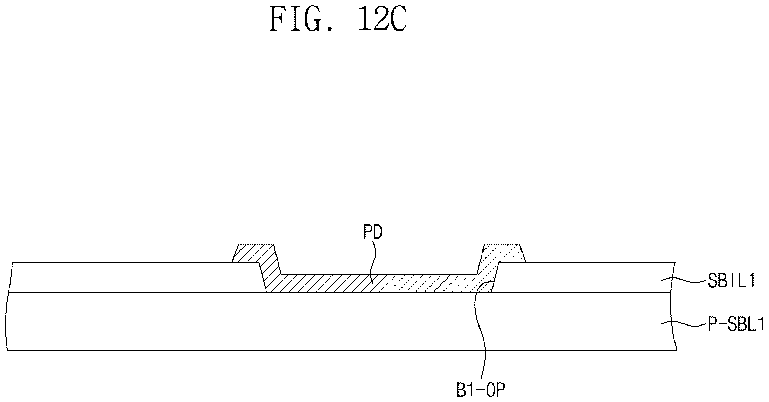

Referring to FIG. 12B, the first sub-base inorganic layer SBIL1 in which the first opening B1-OP is defined may be formed by etching the first preliminary sub-base inorganic layer P-SBIL1 (refer to FIG. 12A). In an embodiment, the first opening B1-OP may be formed in the first sub-base inorganic layer SBIL1 through a photolithography process, for example. Thereafter, the metal layer MTL may be formed on the first sub-base inorganic layer SBIL1. Referring to FIGS. 12B and 12C together, the metal layer MTL may be patterned to form the pad electrode PD. The pad electrode PD may be disposed in the first opening B1-OP. However, the invention is not limited thereto. In an embodiment, as illustrated in FIG. 11, the pad electrode PDa may be overlapped with the entirety of the portion of the non-display region DM-NDA after patterning the metal layer MTL, for example.

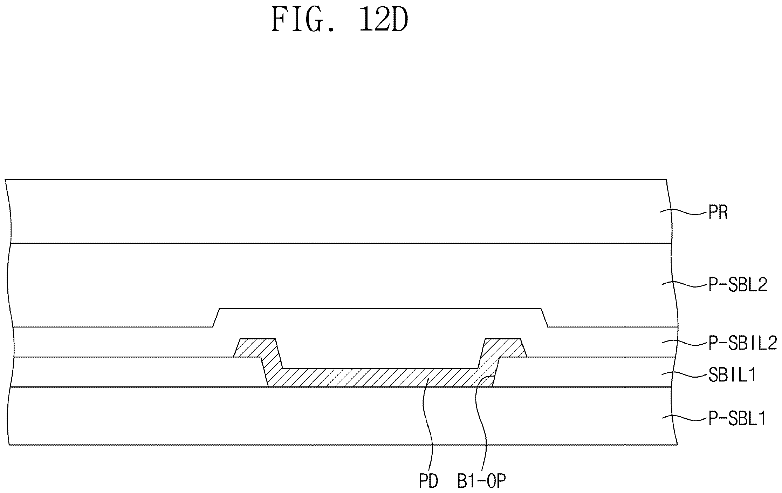

Referring to FIG. 12D, the second preliminary sub-base inorganic layer (also referred to as a second preliminary base layer) P-SBIL2 may be formed on the first sub-base inorganic layer SBIL1 and the pad electrode PD, and the second preliminary sub-base layer P-SBL2 may be formed on the second preliminary sub-base inorganic layer P-SBIL2. The second preliminary sub-base inorganic layer P-SBIL2 and the second preliminary sub-base layer P-SBL2 may be sequentially stacked.

A photoresist layer PR may be disposed on the second preliminary sub-base layer P-SBL2. Referring to FIG. 6 together, the first to fifth insulating layers 10 to 50 and conductive layers CNP1, CNP2, and BML2 may be disposed on the base layer BL of the invention. However, the photoresist layer PR may be disposed on the second preliminary sub-base layer P-SBL2 such that the first to fifth insulating layers 10 to 50 and conductive layers CNP1, CNP2, and BML2 may not be formed in the pad region PA (refer to FIG. 9A). Thereafter, the photoresist layer PR may be removed.

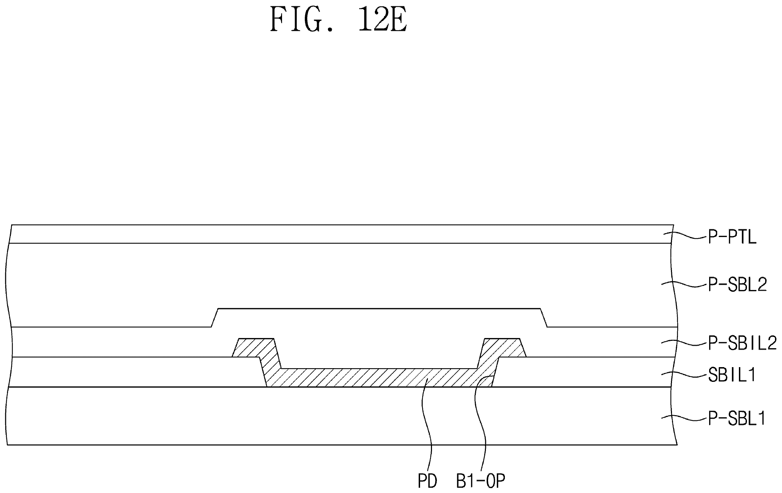

Referring to FIG. 12E, a preliminary protection layer P-PTL may be formed on the second preliminary sub-base layer P-SBL2. The protection layer PTL to be formed from the preliminary protection layer P-PTL may include at least one inorganic layer. In an embodiment, the inorganic layer may include silicon nitride, silicon oxy nitride, or silicon oxide, for example. The amorphous silicon may include amorphous silicon (a-Si).

Referring to FIGS. 12D and 12E together, a preliminary protective layer P-PTL may be disposed to directly contact the second preliminary sub-base layer P-SBL2. In other words, the first to fifth insulating layers 10 to 50 and the conductive layers CNP1, CNP2, and BML2 illustrated in FIG. 6 may not be disposed between the second preliminary sub-base layer P-SBL2 and the preliminary protective layer P-PTL. In an alternative embodiment, the preliminary protective layer P-PTL may be one of the first to fifth insulating layers 10 to 50.

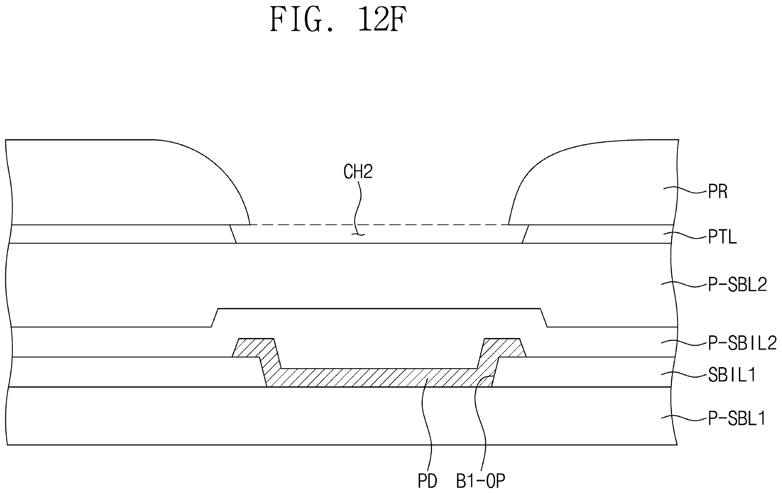

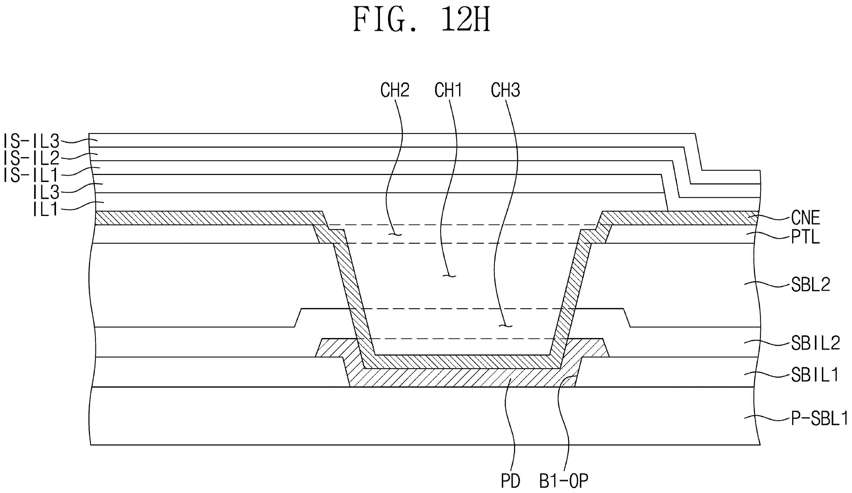

Referring to FIGS. 12E and 12F together, the protective layer PTL may be formed by etching (or a first etching process) the preliminary protective layer P-PTL. In detail, the photoresist layer PR is disposed on the preliminary protective layer P-PTL and the first etching process for the preliminary protective layer P-PTL is performed, thereby forming the contact hole CH2 (or a second contact hole). The first etching process for the preliminary protective layer P-PTL may be performed to prevent a portion of the preliminary protective layer P-PTL from remaining on the second sub-base layer SBL2 (refer to FIG. 12H), when forming the first to third contact holes CH1, CH2, CH3 (refer to FIG. 12H). In an embodiment, the first etching process may be omitted. Although not illustrated, to form the photoresist layer PR, a preliminary photoresist layer is disposed on the preliminary protective layer P-PTL and patterned through a mask. After the first etching is performed, the protective layer PTL in which the second contact hole CH2 is defined may be formed. Thereafter, the photoresist layer PR may be removed.

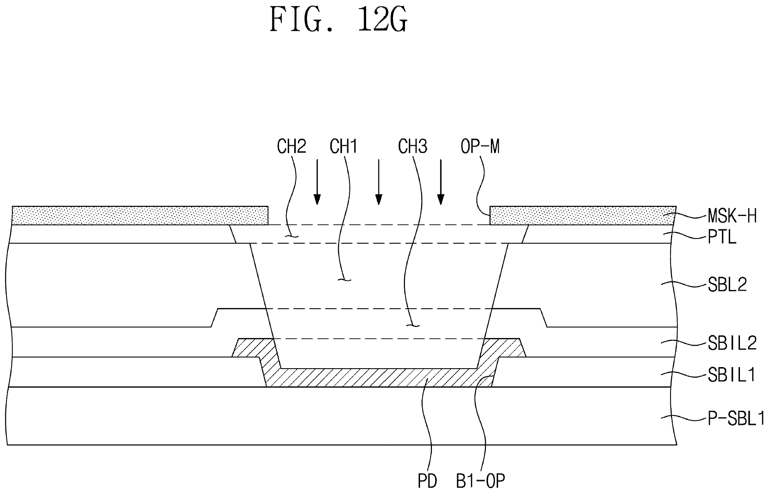

Referring to FIG. 12G, the first contact hole CH1 and the third contact hole CH3 may be formed using a hard mask MSK-H. The hard mask MSK-H may include an IZO mask. After an IZO layer is formed on the protective layer PTL, the mask opening OP-M may be formed in the IZO layer through a photolithography process. The second preliminary sub-base inorganic layer P-SBIL2 and the second preliminary sub-base layer P-SBL2 may be etched (or a second etching process) to form the second sub-base layer SBL2, in which the first contact hole CH1 is defined, and the second sub-base inorganic layer SBIL2, in which the third contact hole CH3, is defined may be formed. The mask including a transparent conductive oxide different from IZO may be used.

In performing the second etching process for the second preliminary sub-base layer P-SBL2, outgas may be emitted to degrade the display quality of the display device DD (refer to FIG. 2). The protective layer PTL may be disposed on the second preliminary sub-base layer P-SBL2 including at least one inorganic layer before the second etching process is performed, thereby reducing the outflow of the outgas emitted as the second preliminary sub-base layer P-SBL2 is etched. Accordingly, the display device DD (refer to FIG. 2) improved in display quality may be provided.

In addition, the second etching process for the second preliminary sub-base inorganic layer P-SBIL2 and the second preliminary sub-base layer P-SBL2 may be performed in the form of a single process to simplify the manufacturing process of the display device (DD, refer to FIG. 2) according to the invention.

Referring to FIG. 12H, the connection electrode CNE may be formed on the pad electrode PD and the protective layer PTL. The connection electrode CNE may be electrically connected to the pad electrode PD through the first to third contact holes CH1, CH2, and CH3. In addition, referring to FIGS. 12E and 12H together, the first to fifth insulating layers 10 to 50 (refer to FIG. 6) and the conductive layers CNP1, CNP2, BML2, refer to FIG. 6) may not be formed between the connection electrode CNE and the protective layer PTL. Accordingly, the connection electrode CNE may be directly disposed on the side surfaces of the first to third contact holes CH1, CH2, and CH3 without a step difference, thereby preventing the connection electrode CNE from being disconnected due to the step difference. In addition, a connection failure between the connection electrode CNE and the pad electrodes PD may be prevented from being caused by residues of the first to fifth insulating layers 10 to 50 and the conductive layers CNP1, CNP2, and BML2. Accordingly, the display device DD (refer to FIG. 2) improved in reliability may be provided.

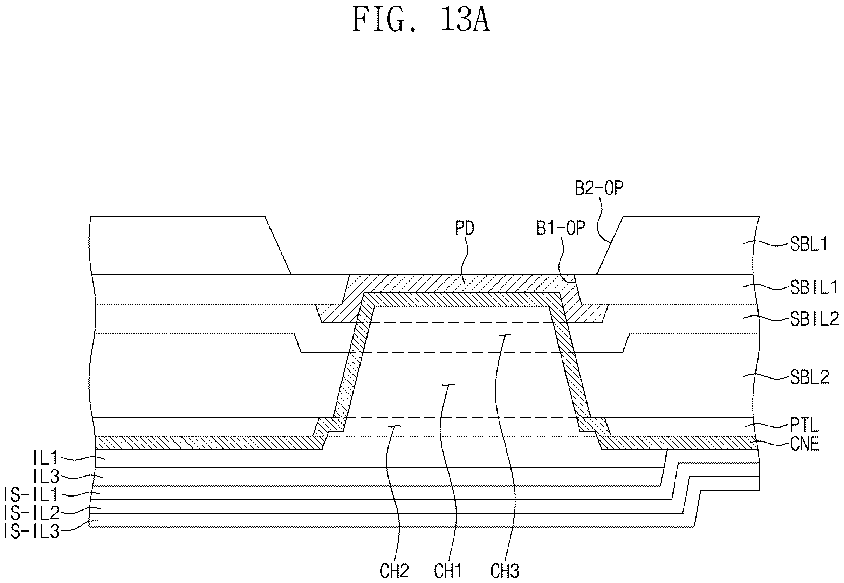

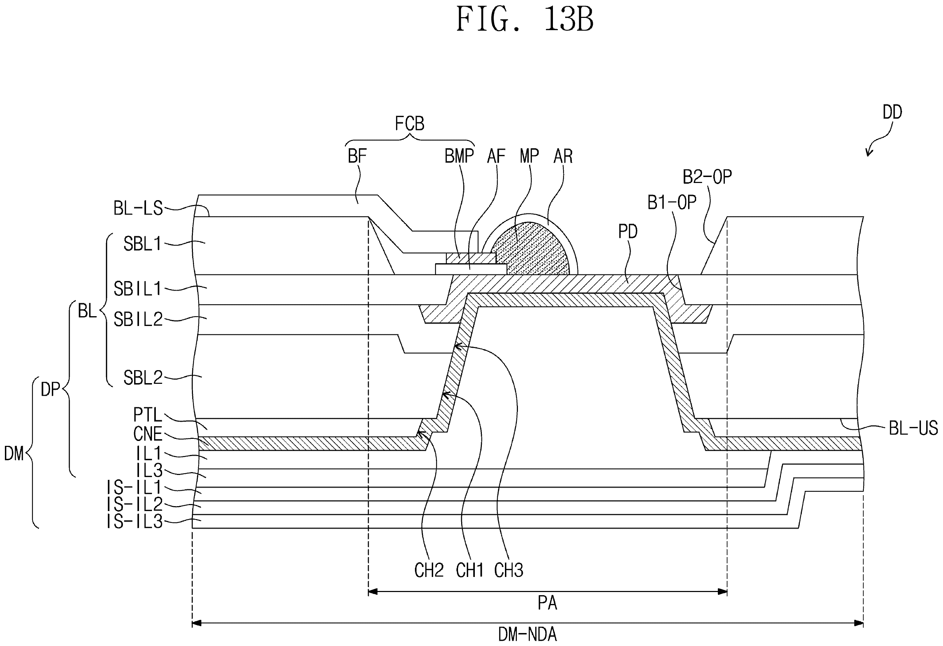

FIGS. 13A and 13B are views illustrating an embodiment of one operation of a method for manufacturing the display device. In detail, FIGS. 13A and 13B illustrate the circuit board FCB (refer to FIG. 2) is coupled to the rear surface of the display module DM (refer to FIG. 2).

Referring to FIG. 13A, after a portion of the display device DD (refer to FIG. 2) illustrated in FIG. 12H is upside down, the operation of forming the first sub-base layer SBL1 by etching the first preliminary sub-base layer P-SBL1 may be performed. Although not illustrated, the photoresist layer is disposed on the first preliminary sub-base layer P-SBL1, and the first preliminary sub-base layer P-SBL1 is etched to form the second opening B2-OP. The pad electrode PD may be directly exposed to the outside through the second opening B2-OP formed through the first preliminary sub-base layer P-SBL1. The pad electrode PD may be exposed to the outside by the width of the second opening B2-OP in the first direction DR1.

Referring to FIG. 13B, the operation of electrically connecting the display module DM to the circuit board FCB according to the invention may be performed. In detail, the circuit board FCB may be disposed on the first surface BL-LS of the base layer BL. The adhesive layer may be interposed between the circuit board FCB and the first surface BL-LS of the base layer BL. The circuit board FCB may be fixed to the first surface BL-LS of the base layer BL by the adhesive layer.

The circuit board FCB may include the base film BF and a bump electrode BMP disposed on the base film BF. The base film BF may be unitary and electrically connected to the bump electrode BMP. The bump electrode BMP may be fixed to the first surface BL-LS of the base layer BL by the adhesive layer AF. Although not illustrated, the circuit board FCB may be attached to the base layer BL while being bent on the first surface BL-LS of the base layer BL.

After that, the operation of forming the metal pattern MP may be performed. The metal pattern MP may be formed by curing a metal ink. The metal pattern MP may be formed by curing the metal ink at a relatively low temperature and then patterning the cured metal ink. The pad electrodes PD and the bump electrodes BMP may be electrically connected to each other and bonded at the same time through the metal pattern MP.

After the operation of forming the metal pattern MP, the operation of forming the adhesive resin AR to cover the metal pattern MP in the second opening B2-OP may be further performed. The adhesive resin AR may include an optical clear resin. However, a material of the adhesive resin AR is not limited thereto. In an embodiment, the material of the adhesive resin AR may include a general adhesive agent or adhesion agent, for example.

As described above, in the display panel according to the invention, the protective layer including the at least one inorganic layer may be provided on the second sub-base layer including the organic material. Accordingly, the outflow of the outgas, which is emitted as the second sub-base layer is etched, may be reduced. Accordingly, the display device improved in the display quality may be provided.

In addition, as the insulating layers and the conductive layers are not provided between the base layer and the protective layer, the connection electrode is directly disposed on the side surface of the contact hole, thereby preventing the connection electrode from being disconnected by the insulating layers and the conductive layers. Accordingly, the connection failure may be prevented from being caused by the residues from the insulating layers and the conductive layers. Accordingly, the display device improved in reliability may be provided.

Although an embodiment of the invention has been described for illustrative purposes, those skilled in the art will appreciate that various modifications, and substitutions are possible, without departing from the scope of the invention as disclosed in the accompanying claims.

Accordingly, the technical scope of the invention is not limited to the detailed description of this specification, but should be defined by the claims.

While the invention has been described with reference to embodiments thereof, it will be apparent to those of ordinary skill in the art that various changes and modifications may be made thereto without departing from the scope of the invention as set forth in the following claims.

## Claims

1. A display panel (DP) comprising:
a first base layer (SBL1) in which an opening (B1-OP) is defined;
a pad electrode (PD) disposed on the first base layer (SBL1) and exposed to an outside through the opening (B1-OP);
a second base layer (SBL2) which is disposed on the pad electrode (PD) and in which a first contact hole (CH1) is defined;
a protective layer (PTL) which is disposed on the second base layer (SBL2) and in which a second contact hole (CH2), which is overlapped with the first contact hole (CH1), is defined; and
a connection electrode (CNE) disposed on the protective layer (PTL) and electrically connected to the pad electrode (PD) through the first contact hole (CH1) and the second contact hole (CH2),
wherein the second contact hole (CH2) has a width greater than a width of the first contact hole (CH1).

2. The display panel (DP) of claim 1, further comprising:
a base insulating layer interposed between the first base layer (SBL1) and the second base layer (SBL2),
wherein a third contact hole (CH3) is defined in the base insulating layer while passing through the base insulating layer.

3. The display panel (DP) of claim 2, wherein the third contact hole (CH3) has a width different from a width of the first contact hole (CH1).

4. The display panel (DP) of claim 2 or 3, wherein a first side surface, which defines the first contact hole (CH1), and a second side surface, which defines the third contact hole (CH3), are aligned in line with each other.

5. The display panel (DP) of at least one of claims 2 to 4, wherein the base insulating layer includes:
a first sub-base insulating layer (SBIL1) disposed on the first base layer (SBL1); and
a second sub-base insulating layer (SBIL2) disposed on the first sub-base insulating layer (SBIL1) and the pad electrode (PD), and
wherein the pad electrode (PD) is disposed in a base opening (B1-OP) defined in the first sub-base insulating layer (SBIL1).

6. The display panel (DP) of claim 5, wherein the third contact hole (CH3) is defined in the second sub-base insulating layer (SBIL2), and
wherein the third contact hole (CH3) is overlapped with the base opening (B1-OP).

7. The display panel (DP) of at least one of claims 1 to 6, wherein the pad electrode (PD) includes:
a first part (B1) overlapped with the opening (B1-OP); and
a second part (B2) extending in a first direction from the first part (B1).

8. The display panel (DP) of claim 7, wherein the connection electrode (CNE) directly contacts the first part (B1).

9. The display panel (DP) of claim 7 or 8, wherein the connection electrode (CNE) directly contacts the second part (B2).

10. The display panel (DP) of at least one of claims 1 to 9, wherein the second base layer (SBL2) includes an organic material.

11. The display panel (DP) of at least one of claims 1 to 10, wherein the protective layer (PTL) includes at least one inorganic layer.

12. The display panel (DP) of at least one of claims 1 to 11, wherein the second base layer (SBL2) has a thickness greater than a thickness of the protective layer (PTL).

13. The display panel (DP) of at least one of claims 1 to 12, wherein the first base layer (SBL1) includes:
a display region (DA) and a non-display region (NDA), and
wherein the pad electrode (PD) is overlapped with the non-display region (NDA).

14. An electronic device comprising:
a housing (HM);
an electronic module (EM) disposed inside the housing (HM); and
a display device (DD) overlapped with the electronic module (EM), the display device (DD) including:
a display panel, in particular a display panel (DP) of at least one of claims 1 to 13, to display an image; the display panel (DP) including:
a first base layer (SBL1) in which an opening (B1-OP) is defined;
a pad electrode (PD) disposed on the first base layer (SBL1), and exposed to an outside through the opening (B1-OP);
a second base layer (SBL2) which is disposed on the pad electrode (PD) and in which a first contact hole (CH1) is defined;
a protective layer (PTL) which is disposed on the second base layer (SBL2) and in which a second contact hole (CH2), which is overlapped with the first contact hole (CH1), is defined; and
a connection electrode (CNE) disposed on the protective layer (PTL) and electrically connected to the pad electrode (PD) through the first contact hole (CH1) and the second contact hole (CH2); and
a circuit board (FCB) coupled to the display panel (DP),
wherein the second contact hole (CH2) has a width greater than a width of the first contact hole (CH1).

15. The electronic device of claim 14, wherein the display panel (DP) further includes:
a first sub-base insulating layer (SBIL1) disposed on the first base layer (SBL1); and
a second sub-base insulating layer (SBIL2) disposed on the first sub-base insulating layer (SBIL1) and the pad electrode (PD), and
wherein the pad electrode (PD) is disposed in a base opening (B1-OP) defined in the first sub-base insulating layer (SBIL1).
